# EUROPEAN PATENT APPLICATION

(11) **EP 4 436 208 A1**
(43) Date of publication of application: **25.09.2024**
(21) Application number: 22894609.1
(22) Date of filing: 28.10.2022
(51) Int. Cl.: H04R 7/02, H04R 7/06, H04R 7/16

(54) **DIAPHRAGM AND LOUDSPEAKER DEVICE**

(30) Priority: 16.11.2021 CN 202111357842; 16.11.2021 CN 202122813370 U; 16.11.2021 CN 202122813402 U; 16.11.2021 CN 202122813263 U
(71) Applicant: Caldron Technologies Ptd. Ltd., Singapore (SG)
(72) Inventor: LI, hao, Beijing (CN); YUAN, Quan, Beijing (CN); LIU, Qian, Beijing (CN)
(74) Representative: Renaudo, Adrien Hanouar
(86) International application number: PCT/CN2022/128308
(87) International publication number: WO 2023/088072

(57) **Abstract**

Embodiments of the present disclosure provide a diaphragm and an audio device. The diaphragm comprises: at least one insulating film, a plurality of conductive films, and a plurality of connecting pieces. The insulating film is provided with a magnetic pole corresponding area. Each of the conductive films is connected at least to one insulating film, the plurality of conductive films is arranged with an interval, and the magnetic pole corresponding regions are respectively arranged on the two sides of each conductive film. The plurality of conductive films is connected in series by means of the plurality of connecting pieces to form an energized circuit. According to the technical solution provided in the embodiments of the present disclosure, the at least one insulating film is connected with the plurality of conductive films arranged with an interval, and the magnetic pole corresponding regions are respectively arranged on the two sides of each conductive film, such that a conductive film having a relatively large area can be located in a relatively strong magnetic field, each conductive film also emits low-frequency sound that meets user's needs, and the conductive film can cover the high, medium and low frequency spectrum.

## Description

### CROSS-REFERENCE TO RELATED APPLICATIONS

The present disclosure refers to Chinese Patent Applications in the following table, which are hereby incorporated by reference in their entireties.

| Application Date | Application No. | Application Title |
|---|---|---|
| 2021-11-16 | 2021113578429 | A Diaphragm and An Audio device |
| 2021-11-16 | 2021228133705 | A Diaphragm and An Audio device |
| 2021-11-16 | 2021228134021 | A Sounding Unit and An Audio device |
| 2021-11-16 | 2021228132632 | A Diaphragm and An Audio device |

### TECHNICAL FIELD

The present disclosure relates to the technical field of sound-generating device, and in particular to a diaphragm and a sound device.

### BACKGROUND

Traditional speakers are generally designed to produce sound by using a conductive coil in a magnetic field to drive the paper cone to vibrate, converting the electric current into a sound signal. However, the paper cone consumes a lot of energy to offset inertia during the vibration process, so the ability of the paper cone is limited for signals with higher vibration frequencies. This property makes this design more suitable for bass signals. With the development of technology, a ribbon speaker is becoming more and more popular among users, the principle of which is to apply audio current to a conductive film placed in a uniform magnetic field. When the energized conductive film passes through the magnetic field, it will be affected by the magnetic field force. By changing the direction and magnitude of the audio current, the direction and magnitude of the magnetic field force on the conductive film will also change, causing the conductive film to vibrate and make sound.

Nowadays, conventional ribbon speakers can perfectly reproduce high-frequency and ultra-high-frequency signals, and timbre and sound quality of which are unique, but conventional ribbon speakers cannot produce bass very well, so when users use them, conventional ribbon speakers cannot perfectly cover the high, medium and low frequency spectrum, and thus cannot meet the user's usage needs.

### SUMMARY

In order to solve or improve the above problems, an embodiment of the present disclosure provides a diaphragm and an audio device.

In one embodiment of the present disclosure, a diaphragm is provided, comprising:
at least one insulating film, wherein the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit. Preferably, one insulating film is provided, the insulating film comprises a first surface and a second surface arranged opposite to each other;
the plurality of conductive films is all connected with the first surface; or
the plurality of conductive films comprises a plurality of first sub-films and a plurality of second sub-films, wherein the plurality of first sub-films is arranged on the first surface, the plurality of second sub-films is arranged on the second surface, and the first sub-films and the second sub-films are arranged with an interval.

Preferably, two stacked insulating films are provided, and the plurality of conductive films is arranged between the two insulating films.

Preferably, an insulating structure is provided between two adjacent conductive films. Preferably, the insulating film comprises a plurality of insulating films, and the plurality of insulating films and the plurality of conductive films are sequentially connected at intervals.

Preferably, insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

Preferably, the connecting piece comprises a connecting film arranged on the insulating film; or
the connecting piece comprise a conductive wire.

Preferably, the conductive film is provided with a feedback wire, and the feedback wire extends along a direction of current flow in the energized circuit.

Preferably, the conductive film comprises at least one of gold, silver, copper, iron, aluminum, graphite, graphene, carbon fiber, polymer material and composite material. Preferably, the insulating film comprises at least one of spandex material, silicone material, rubber material, polyester film, polyester fiber or other polymer materials. Preferably, each of the conductive films comprises a plurality of segmented films, and each of the plurality of segmented films in each of the conductive films extends along a direction of current flow in the energized circuit;
from one magnetic pole corresponding area to another magnetic pole corresponding area, the plurality of segmented films is arranged with an interval.

Preferably, one insulating film is provided, the insulating film comprises a first surface and a second surface arranged opposite to each other;
the plurality of the segmented films is all connected with the first surface, and an insulating structure is provided between two adjacent segmented films; or
the plurality of segmented films comprises a plurality of first sub-segmented films and a plurality of second sub-segmented films, the plurality of first sub-segmented films is arranged on the first surface, the plurality of second sub-segmented films is arranged on the second surface, and the first sub-segmented films and the second sub-segmented films are arranged with an interval.

Preferably, two stacked insulating films are provided, and the plurality of segmented films is arranged between the two insulating films.

Preferably, an insulating structure is provided between two adjacent segmented films. Preferably, from one magnetic pole corresponding area to another magnetic pole corresponding area, sizes of the plurality of segmented films are equal, or, a size of the segmented film becomes larger when be closer to the magnetic pole corresponding area.

In another embodiment of the present disclosure, an audio device is further provided, the audio device comprising the diaphragm;
a plurality of magnet groups, wherein the plurality of magnet groups is arranged with an interval, each of the magnet groups comprises a pair of magnets with the same magnetic poles arranged opposite to each other, an opposing gap is provided between each pair of the magnets, and an energized gap is provided between two adjacent magnet groups with opposite magnetic poles arranged opposite to each other; and
the diaphragm is passed through the opposing gap, each of the magnet groups is arranged corresponding to one magnetic pole corresponding area, and the conductive film is arranged in the energized gap.

Preferably, the audio device further comprises: a plurality of magnetic conductors, and two adjacent magnet groups with opposite magnetic poles arranged opposite to each other are respectively connected with two ends of the magnetic conductors.

In addition, preferably, the audio device further comprises: a signal input circuit, a signal amplifier and a feedback circuit; wherein,
the signal input circuit has an input end and an output end, the input end is used to receive an external input signal, and the output end is connected with the signal amplifier;
the signal amplifier has an input port and an output port, the input port is connected with the output end, and the output port is connected with the energized circuit on the diaphragm; and
the feedback wire on the conductive film is connected with one end of the feedback circuit, and the other end of the feedback circuit is connected with the input port.

In another embodiment of the present disclosure, a diaphragm is further provided, comprising:
at least one insulating film, wherein the insulating film is provided with a magnetic pole corresponding area;
a plurality of conductive films, wherein each of the conductive films is at least connected with one of the insulating films, the plurality of conductive films is arranged with an interval, and two sides of each of the conductive films are provided with the magnetic pole corresponding area respectively.

In the technical solution provided in the embodiment of the present disclosure, at least one insulating film is connected with a plurality of conductive films arranged with an interval, and the magnetic pole corresponding area are respectively provided on both sides of each conductive film. In a specific embodiment, a magnet can be arranged in the magnetic pole corresponding area, and by reasonably arranging the area of each conductive film, since under a certain energy condition, the larger the area of the conductive film, the smaller the amplitude of the conductive film, each conductive film can also emit a low-frequency sound that meets the user's needs, so that the conductive film can cover the high, medium and low frequency spectrum.

In one embodiment of the present disclosure, a sounding unit is provided, the sounding unit comprising: a mounting bracket, a plurality of magnet groups and a diaphragm, wherein the mounting bracket has a magnet mounting area and a diaphragm mounting area;
the plurality of magnet groups is arranged in the magnet mounting area and is arranged with an interval, each of the magnet groups comprises a pair of magnets with the same magnetic poles arranged opposite to each other, an opposing gap is provided between each pair of the magnets, and a circuit placement area is provided between two adjacent magnet groups with opposite magnetic poles arranged opposite to each other;
the diaphragm is arranged in the diaphragm mounting area, the diaphragm is provided with a plurality of magnetic pole corresponding areas and an energized circuit, the diaphragm is passed through the opposing gap, each of the magnet groups is arranged corresponding to one magnetic pole corresponding area, and the energized circuit is arranged in the circuit placement area.

Preferably, the magnet group is arranged along a height direction of the mounting bracket to form a magnet column, and a plurality of the magnet columns is arranged with an interval along a width direction of the mounting bracket;
one magnet group is arranged in the magnet column, and the opposing magnetic poles of two magnet groups in adjacent magnet columns are opposite; or
a plurality of magnet groups is provided in the magnet column, and the plurality of magnet groups is arranged with an interval along a height direction of the mounting bracket, in the same magnet column, the opposing magnetic poles of two adjacent magnet groups are the same, and the opposing magnetic poles of two magnet groups in adjacent magnet columns are opposite.

Preferably, the sounding unit further comprises: a plurality of magnetic conductors, wherein the plurality of magnetic conductors is arranged with an interval along a height direction of the mounting bracket, and a gap is provided between two adjacent magnetic conductors;
the magnetic conductor extends along a width direction of the mounting bracket and spans across the plurality of magnet columns, and is respectively connected with the magnet group with opposite magnetic poles arranged opposite to each other in adjacent magnet columns.

Preferably, a pole of the magnet column facing away from the diaphragm is provided with a magnetic field conductor, the magnetic conductor is connected with the magnetic field conductor.

Preferably, the mounting bracket comprises an upper bracket plate, a lower bracket plate and a plurality of pairs of vertical plates;
the plurality of pairs of the vertical plates is arranged with an interval between the upper bracket plate and the lower bracket plate, and an accommodation gap is provided between two the vertical plates in pairs;
at least one of the upper bracket plate and the lower bracket plate is provided with a mounting hole, the mounting hole extends along an arrangement direction of the plurality of pairs of vertical plates and corresponding to the accommodation gap;
a side of the vertical plate facing the accommodation gap is the magnet mounting area, and the accommodation gap and the mounting hole form the diaphragm mounting area.

Preferably, the mounting bracket comprises a first bracket plate and a second bracket plate;
the first bracket plate and the second bracket plate are arranged opposite to each other, and a mounting gap is provided between the first bracket plate and the second bracket plate;
the magnet group is arranged in the mounting gap, and one magnet in each of the magnet groups is connected with the first bracket plate, and the other magnet is connected with the second bracket plate;
the first bracket plate and the second bracket plate are provided with a sound-transmitting structure.

Preferably, the diaphragm comprises:
at least one insulating film, wherein the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit. Preferably, one insulating film is provided, the insulating film comprises a first
surface and a second surface arranged opposite to each other;
the plurality of conductive films is all connected with the first surface; or
the plurality of conductive films comprises a plurality of first sub-films and a plurality of second sub-films, wherein the plurality of first sub-films is arranged on the first surface, the plurality of second sub-films is arranged on the second surface, and the first sub-films and the second sub-films are arranged with an interval.

Preferably, two stacked insulating films are provided, and the plurality of conductive films is arranged between the two insulating films.

Preferably, an insulating structure is provided between two adjacent conductive films. Preferably, the insulating film comprises a plurality of insulating films, and the plurality of insulating films and the plurality of conductive films are sequentially connected at intervals.

Preferably, the insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

Preferably, the connecting piece comprises a connecting film arranged on the insulating film; or
the connecting piece comprise a conductive wire.

Preferably, the conductive film is provided with a feedback wire, and the feedback wire extends along a direction of current flow in the energized circuit.

Preferably, each of the conductive films comprises a plurality of segmented films, and each of the plurality of segmented films of each of the conductive films extends along a direction of current flow in the energized circuit;
from one magnetic pole corresponding area to another magnetic pole corresponding area, the plurality of segmented films is arranged with an interval.

Preferably, one insulating film is provided, the insulating film comprises a first surface and a second surface arranged opposite to each other;
the plurality of the segmented films is all connected with the first surface, and an insulating structure is provided between two adjacent segmented films; or the plurality of segmented films comprises a plurality of first sub-segmented films and a plurality of second sub-segmented films, the plurality of first sub-segmented films is arranged on the first surface, the plurality of second sub-segmented films is arranged on the second surface, and the first sub-segmented films and the second sub-segmented films are arranged with an interval.

Preferably, two stacked insulating films are provided, and the plurality of segmented films is arranged between the two insulating films.

Preferably, an insulating structure is provided between two adjacent segmented films. Preferably, from one magnetic pole corresponding area to another magnetic pole corresponding area, sizes of the plurality of segmented films are equal, or, a size of the segmented film becomes larger when be closer to the magnetic pole corresponding area.

Another embodiment of the present disclosure provides an audio device, the audio device comprises: a device main body and the above-mentioned sounding unit arranged on the device main body.

In addition, preferably, the audio device further comprises: a signal input circuit, a signal amplifier and a feedback circuit; wherein,
the signal input circuit has an input end and an output end, the input end is used to receive an external input signal, and the output end is connected with the signal amplifier;
the signal amplifier has an input port and an output port, the input port is connected with the output end, and the output port is connected with the energized circuit on the diaphragm; and
the feedback wire on the conductive film is connected with one end of the feedback circuit, and the other end of the feedback circuit is connected with the input port.

In the technical solution provided in the embodiment of the present disclosure, a plurality of magnet groups and a diaphragm are arranged on a mounting bracket and a circuit gap is provided between adjacent magnet groups, a plurality of magnetic pole corresponding areas is provided on the diaphragm, each magnet group corresponds to one magnetic pole corresponding area, and the energized circuit on the diaphragm is arranged in the circuit gap, thereby enabling an energized circuit with relative larger unit area to be arranged in a stronger magnetic field. Since under a certain energy condition, the larger the area of the conductive film, the smaller the amplitude of the conductive film, under the drive of the bass signal, the energized circuit can also emit low-frequency sound that meets user's needs, so that this sounding unit can cover the high, medium and low frequency spectrum.

One embodiment of the present disclosure provides a diaphragm, comprising:
at least one insulating film, wherein the insulating film is an open mesh or a non-open film made of viscoelastic material; the insulating film has a connecting end, and the connecting end is provided with a viscoelastic connection structure; the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit. Preferably, the insulating film is one of a spandex open mesh, a silicone film, a rubber film, a polyester film, and a polyester fiber film having viscoelastic properties. Preferably, the viscoelastic connection structure is a viscoelastic glue.

Preferably, a plurality of weakening structures for reducing a strength of the conductive film are provided on the conductive film.

Preferably, the weakening structure includes a pleated structure and/or a hole structure.

Preferably, one insulating film is provided, the insulating film comprises a first surface and a second surface arranged opposite to each other;
the plurality of conductive films is all connected with the first surface; or
the plurality of conductive films comprises a plurality of first sub-films and a plurality of second sub-films, wherein the plurality of first sub-films is arranged on the first surface, the plurality of second sub-films is arranged on the second surface, and the first sub-films and the second sub-films are arranged with an interval.

Preferably, two stacked insulating films are provided, and the plurality of conductive films is arranged between the two insulating films.

Preferably, the insulating film comprises a plurality of insulating films, and the plurality of insulating films and the plurality of conductive films are sequentially connected at intervals.

Preferably, the insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

Preferably, the connecting piece comprises a connecting film arranged on the insulating film; or
the connecting piece comprise a conductive wire.

Preferably, the conductive film is provided with a feedback wire, and the feedback wire extends along a direction of current flow in the energized circuit.

Preferably, each of the conductive films comprises a plurality of segmented films, and each of the plurality of segmented films in each of the conductive films extends along a direction of current flow in the energized circuit;
from one magnetic pole corresponding area to another magnetic pole corresponding area, the plurality of segmented films is arranged with an interval.

Preferably, from one magnetic pole corresponding area to another magnetic pole corresponding area, sizes of the plurality of segmented films are equal, or, a size of the segmented film becomes larger when be closer to the magnetic pole corresponding area.

Correspondingly, the embodiment of the present disclosure provides an audio device, comprising: the above-mentioned diaphragm, and
a plurality of magnets, wherein the plurality of magnets is arranged respectively corresponding to the magnetic pole corresponding area, and the energized circuit is located between two adjacent magnets with opposite magnetic poles facing the diaphragm.

Preferably, the plurality of magnets comprises a plurality of magnet groups, each of the magnet groups comprises a pair of magnets with the same magnetic poles arranged opposite to each other, an opposing gap is provided between each pair of the magnets, and an energized gap is provided between two adjacent magnet groups with opposite magnetic poles arranged opposite to each other;
the diaphragm is passed through the opposing gap, and the energized circuit is arranged in the energized gap.

Preferably, the plurality of magnets comprises a plurality of first sub-magnets and a plurality of second sub-magnets, and the magnetic poles of the first sub-magnets facing the diaphragm are opposite to the magnetic poles of the second sub-magnets facing the diaphragm;
the plurality of first sub-magnets and the plurality of second sub-magnets are arranged with an interval and staggered on opposite sides of the diaphragm; or, the plurality of first sub-magnets and the plurality of second sub-magnets are arranged with an interval on the same side of the diaphragm.

Preferably, when the plurality of the first sub-magnets and the plurality of the second sub-magnets are arranged with an interval on the same side of the diaphragm, a sound insulation structure is provided between the first sub-magnet and the second sub-magnet.

In addition, preferably, the audio device further comprises: a signal input circuit, a signal amplifier and a feedback circuit; wherein,
the signal input circuit is connected with the signal amplifier, and the signal amplifier is connected with the diaphragm; and
the feedback circuit is respectively connected with the feedback wire on the conductive film in the diaphragm and the signal amplifier, and is used to feed back a vibration frequency of the diaphragm in the diaphragm to the signal amplifier.

In the technical solution provided in the embodiment of the present disclosure, a viscoelastic connection structure is provided on the insulating film, and the insulating film is fixedly connected through the viscoelastic connection structure. When the diaphragm vibrates, the vibration energy transmitted from the diaphragm is absorbed by the viscoelastic connection structure, thereby reducing the negative impact of the vibration on the vibration of the diaphragm itself caused by the reverse propagation after encountering the fixed point. The viscoelastic connection structure and the insulating film (mesh) provide tension and displacement in the vibration direction for the diaphragm, thereby increasing the amplitude of the diaphragm and reducing bass loss. At the same time, the delay in the time domain of sound generation is reduced, so as to better show the state of the original sound when the sound is played.

### BRIEF DESCRIPTION OF THE DRAWINGS

In order to describe the technical solutions in the embodiments of the present disclosure or the prior art more clearly, the drawings required to be used for descriptions about the embodiments or the prior art will be simply introduced below. It is apparent that the drawings described below are some embodiments of the present disclosure. Those of ordinary skill in the art may further obtain other drawings according to these drawings without creative work.

In order to describe the technical solutions in the embodiments of the present disclosure or the prior art more clearly, the drawings required to be used for descriptions about the embodiments or the prior art will be simply introduced below. It is apparent that the drawings described below are some embodiments of the present disclosure. Those of ordinary skill in the art may further obtain other drawings according to these drawings without creative work.
FIG. 1 is a schematic diagram of a three-dimensional structure of a diaphragm provided in an embodiment of the present disclosure;
FIG. 2 is a schematic diagram of a top-view of a diaphragm provided in an embodiment of the present disclosure;
FIG. 3 is a schematic diagram of a structure of a diaphragm provided in an embodiment of the present disclosure;
FIG. 4 is another schematic diagram of a structure of a diaphragm provided in an embodiment of the present disclosure;
FIG. 5 is a schematic diagram of a three-dimensional structure of a diaphragm provided in an embodiment of the present disclosure;
FIG. 6 is a schematic diagram of a structure of a diaphragm provided in an embodiment of the present disclosure;
FIG. 7 is another schematic diagram of a structure of a diaphragm provided in an embodiment of the present disclosure;
FIG. 8 is a schematic diagram of a structure of a diaphragm provided in an embodiment of the present disclosure;
FIG. 9 is a schematic structural diagram of a plurality of sub-segmented films of a diaphragm provided in an embodiment of the present disclosure;
FIG. 10 is a schematic diagram of a structure of a plurality of sub-segmented films provided in an embodiment of the present disclosure;
FIG. 11 is a schematic diagram of a usage state of a diaphragm provided in an embodiment of the present disclosure;
FIG. 12 is a schematic diagram of a structure of an audio device provided in an embodiment of the present disclosure;
FIG. 13 is a schematic diagram of a shape of a diaphragm and a distribution diagram of a magnetic pole corresponding area provided in an embodiment of the present disclosure;
FIG. 14 is a schematic diagram of a shape of a diaphragm and a distribution diagram of a magnetic pole corresponding area provided in an embodiment of the present disclosure;
FIG. 15 is a schematic diagram of a shape of another diaphragm and a distribution diagram of a magnetic pole corresponding area provided in an embodiment of the present disclosure;
FIG. 16 is a schematic diagram of a three-dimensional structure of a sounding unit provided in an embodiment of the present disclosure;
FIG. 17 is a schematic cross-sectional view of the structure along the A-A direction in FIG. 1;
FIG. 17a is a schematic diagram of a partial structure of a sounding unit provided in an embodiment of the present disclosure;
FIG. 18 is a schematic diagram of a right-view structure of a sounding unit provided in an embodiment of the present disclosure;
FIG. 19 is a schematic diagram of a front-view structure of a sounding unit provided in an embodiment of the present disclosure;
FIG. 20 is a schematic cross-sectional view of the structure along the A-A direction in FIG. 19;
FIG. 21 is a schematic diagram of a front-view structure of another sounding unit provided in an embodiment of the present disclosure;
FIG. 22 is a schematic diagram of a top-view of another sounding unit provided in an embodiment of the present disclosure;
FIG. 23 is a schematic diagram of a front-view structure of another sounding unit provided in an embodiment of the present disclosure;
FIG. 24 is a schematic diagram of a top-view of another sounding unit provided in an embodiment of the present disclosure;
FIG. 25 is a schematic diagram of a planar structure of a diaphragm provided in an embodiment of the present disclosure;
FIG. 26 is a schematic diagram of a vibration state of a diaphragm provided in an embodiment of the present disclosure; and
FIG. 27 is a circuit diagram of an audio device provided in accordance with an embodiment of the present disclosure.

### DETAILED DESCRIPTION OF EXAMPLE EMBODIMENTS

In order to enable those skilled in the prior art to better understand the present application, the technical solution provided by various embodiments of the present application are illustrated in detail and completely in conjunction with the drawings. It is apparent that the described embodiments are not all embodiments but part of embodiments of the present disclosure. All other embodiments obtained by those of ordinary skill in the art on the basis of the embodiments in the present disclosure without creative work shall fall within the scope of protection of the present disclosure.

It should be noted that, in the description of the present disclosure, the terms "first" and "second" are only used to facilitate the description of different components or names, and cannot be understood as indicating or implying an order relationship, relative importance, or implicitly indicating the number of the indicated technical features. Therefore, the features defined as "first" or "second" may explicitly or implicitly include at least one of the features.

Unless defined otherwise, all technical and scientific terms used herein have the same meaning as commonly understood by one of ordinary skill in the art to which the present disclosure belongs. The terms used herein in the specification of the present disclosure are only for the purpose of describing specific embodiments and are not intended to limit the present disclosure.

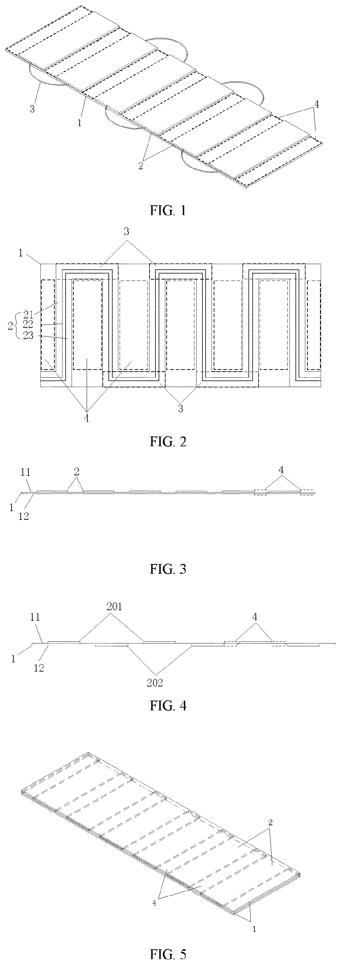

FIG. 1 is a schematic diagram of a three-dimensional structure of a diaphragm provided in an embodiment of the present disclosure, and FIG. 2 is a schematic diagram of a top-view of a diaphragm provided in an embodiment of the present disclosure. Referring to FIGs. 1 and 2, in the diaphragm provided in an embodiment of the present disclosure, the diaphragm includes at least one insulating film 1, a plurality of conductive films 2 and a plurality of connecting pieces 3. The insulating film 1 is provided with a magnetic pole corresponding area 4 for placing a magnet. Each conductive film 2 is at least connected with one insulating film 1. A plurality of conductive films 2 is arranged with an interval, and two sides of each conductive film 2 are provided with a magnetic pole corresponding area 4. The plurality of conductive films 2 is connected in series via the plurality of connecting pieces 3 to form an energized circuit. The insulating film 1 not only has an insulating effect, but also has a certain elasticity. When the diaphragm vibrates, the insulating film 1 can stretch and shrink to a certain extent. In the technical solution provided in the embodiment of the present disclosure, at least one insulating film 1 is connected with a plurality of conductive films 2 which is arranged with an interval, and the magnetic pole corresponding area 4 is respectively provided on two sides of each conductive film 2. In a specific embodiment, a magnet can be set in the magnetic pole corresponding area 4, and by reasonably arranging the area of each conductive film 2, since under a certain energy condition, the larger the area of the conductive film 2, the smaller the amplitude of the conductive film 2, each conductive film 2 can also emit a low-frequency sound that meets the user's needs, so that the conductive film 2 can cover the high, medium and low frequency spectrum.

The technical solution provided in the embodiments of the present disclosure is further described in detail below.

Referring to FIG. 3, in one embodiment of the present disclosure, the diaphragm includes one insulating film 1, and the insulating film 1 includes a first surface 11 and a second surface 12 arranged opposite to each other, and the plurality of conductive films 2 are all connected with the first surface 11. The plurality of conductive films 2 are arranged in parallel and at intervals, and the distances between adjacent conductive films 2 may be the same or different. A magnetic pole corresponding area 4 is provided on two sides of each conductive film 2 (The area where the dotted box in the drawings is located is the magnetic pole corresponding area 4, and only part of the magnetic pole corresponding area 4 is shown in the drawings. The magnetic pole corresponding area 4 in other positions is not shown in the drawings, which does not mean that it does not exist. At the same time, the area size of the dotted box does not represent the area size of the magnetic pole corresponding area 4, which is only used to indicate the position relationship of the magnetic pole corresponding area 4 relative to the diaphragm.), and the magnetic pole corresponding area 4 is distributed on the first surface 11 and the second surface 12 of the insulating film 1 at the same time. There are many connection ways between the plurality of conductive films 2 and the insulating film 1. One way is that the plurality of conductive films 2 is connected with the insulating film 1 by gluing, or another way is to adhere a layer of the material of the conductive film 2 on the insulating film 1 and then etch a plurality of conductive films 2 on the conductive film 2 by etching.

In another embodiment provided in the present disclosure, as shown in FIG. 4, the diaphragm includes one insulating film 1. The insulating film 1 includes a first surface 11 and a second surface 12 arranged opposite to each other, a plurality of conductive films 2 includes a plurality of first sub-films 201 and a plurality of second sub-films 202, the plurality of first sub-films 201 is arranged on the first surface 11, the plurality of second sub-films 202 is arranged on the second surface 12, and the first sub-film 201 and the second sub-film 202 are arranged with an interval. The first sub-film 201 and the second sub-film 202 are arranged with an interval not only in the horizontal direction, but also arranged with an interval in the vertical direction (in FIG. 4, the length direction of the insulating film 1 is defined as the horizontal direction, and the thickness direction of the insulating film 1 is defined as the width direction). The distances between adjacent first sub-films 201 and second sub-films 202 in the horizontal direction can be the same or different, and the width of the corresponding magnetic pole corresponding area 4 in the horizontal direction can also be the same or different. In the specific implementation process, the distance is determined by the size of the magnet volume placed in the adjacent magnetic pole corresponding areas 4. In the technical solution provided in the embodiment of the present disclosure, since two sides of each conductive film 2 are all provided with the magnetic pole corresponding area 4, when the area of each conductive film 2 is large, the magnet located in the magnetic pole corresponding area 4 can still provide a strong magnetic field for the conductive film 2.

Referring to FIG. 5, in one embodiment provided in the present disclosure, the diaphragm includes two insulating films 1 stacked together, and a plurality of conductive films 2 is arranged between the two insulating films 1. The plurality of conductive films 2 are arranged in parallel, and two sides of each conductive film 2 are all provided with a magnetic pole corresponding areas 4. Two sides of the diaphragm are all distributed with the magnetic pole corresponding area 4 and adjacent conductive films 2 are arranged with an interval. The conductive film 2 is arranged between two layers of insulating films 1, which can effectively isolate the air from contacting the conductive film 2, thereby extending the service life of the conductive film 2 and increasing the structural strength of the diaphragm. Furthermore, in order to achieve better insulation between adjacent conductive films 2, an insulating structure may be provided between two adjacent conductive films 2, and the insulating structure is also located between two insulating films 1. In another embodiment of the present disclosure, two insulating films 1 may be directly bonded between two adjacent conductive films 2, which may also play an insulating role.

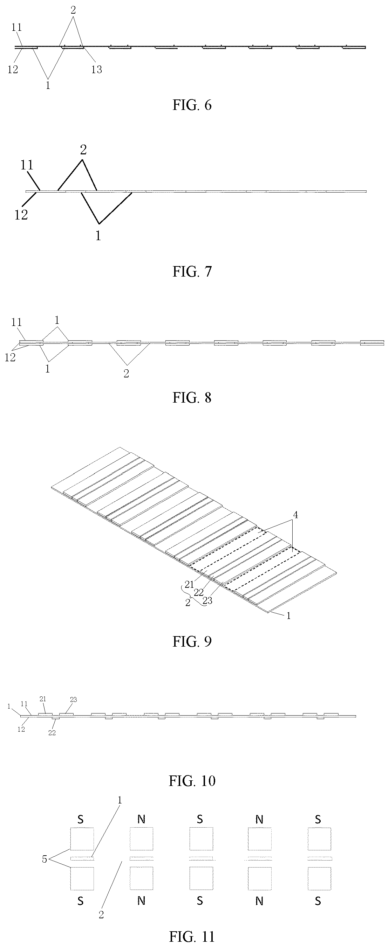

In an embodiment provided in the present disclosure, referring to FIG. 6, the diaphragm includes a plurality of insulating films 1 and a plurality of conductive films 2, and the plurality of insulating films 1 and the plurality of conductive films 2 are sequentially connected at intervals. Two sides of one conductive film 2 are connected with one insulating film 1 respectively, and two sides of one insulating film 1 are connected with two conductive films 2 respectively (except the insulating film 1 or the conductive film 2 at the two ends of the diaphragm).

Furthermore, the insulating film 1 includes a first surface 11 and a second surface 12 arranged opposite to each other, and a side surface 13 arranged between the first surface 11 and the second surface 12. Referring to FIG. 6, the plurality of conductive films 2 are all connected with the first surface 11, two ends of the conductive film 2 are connected with two insulating films 1 respectively, and two ends of the first surface 11 of the insulating film 1 are connected with two conductive films 2 respectively. The plurality of conductive films 2 is approximately on one same plane, and the plurality of insulating films 1 is also approximately on one same plane. The plane where the conductive films 2 are located is different from the plane where the insulating films 1 are located, and said two planes are parallel to each other.

In another embodiment of the present disclosure, referring to FIG. 7, the plurality of conductive films 2 is all connected with the side surface 13, the diaphragm is a one-layer structure, and the plurality of conductive films 2 and the plurality of insulating films 1 are substantially on one same plane. Two sides of one conductive film 2 are connected with two insulating films 1 respectively, and similarly, two sides of one insulating film 1 are connected with two conductive films 2 respectively. Alternatively, referring to FIG. 8, two sides of the conductive film 2 are provided the insulating film 1 respectively, and the conductive film 2 is connected with a first surface 11 of one of the insulating films 1, and is connected with a second surface 12 of another insulating film 1. The conductive film 2 is located between the two insulating films 1, each end of one conductive film 2 is connected with two insulating films 1 respectively, an upper surface of one end of the conductive film 2 is connected with the second surface 12 of one insulating film 1, and a lower surface of one end of the conductive film 2 is connected with the first surface 11 of another insulating film 1. By connecting a plurality of conductive films 2 with a plurality of insulating films 1, the weight of the diaphragm can be effectively reduced.

In an embodiment provided in the present disclosure, referring to FIG. 1 and FIG. 2, the connecting piece 3 includes a connecting film arranged on the insulating film 1, or the connecting piece 3 includes a conductive wire. When the diaphragm is in a magnetic field, the diaphragm will vibrate only when current flows through the conductive film 2 on the diaphragm. In order to allow each conductive film 2 to have current flowing through it in a preset direction, a plurality of conductive films 2 can be connected through the connecting piece 3. Since the adjacent conductive films 2 are in magnetic fields with different directions, in order to make the vibration directions of the plurality of conductive films 2 the same at the same time, the current directions in the adjacent conductive films 2 are different. By connecting the connecting pieces 3 in series, the directions of the currents flowing through the adjacent conductive films 2 can be made different.

Furthermore, in order to simplify the structure of the diaphragm, referring to FIG. 2, the connecting piece 3 is also arranged on the insulating film 1, and the connecting piece 3 is located at two ends of the magnetic pole corresponding area 4, and the flow direction of the current in the connecting piece 3 is the same as or opposite to the direction of the magnetic field (the flow direction of the current is not perpendicular to the magnetic field), so that when current passes through the connecting piece 3, the connecting piece 3 does not generate force with the magnetic field and vibrate. Furthermore, in order to reduce the weight of the diaphragm, referring to FIG. 1, the connecting piece 3 can be a conductive wire, one end of which is connected with one end of one conductive film 2, and the other end is simultaneously connected with one end of another conductive film 2. The two ends of each conductive film 2 are respectively connected with two adjacent different conductive films 2 on two sides thereof through two sections of wires, and the two sections of wires are respectively located at the two ends of the conductive film 2.

In order to accurately detect the vibration frequency and amplitude of the conductive film 2 or the diaphragm, detecting the vibration frequency and amplitude of the diaphragm is also equivalent to detecting the frequency and sound intensity of the emitted sound. In one embodiment of the present disclosure, the conductive film 2 is provided with a feedback wire (not shown in the drawings), and the feedback wire and the conductive film 2 are circuit-isolated from each other (circuit isolation means that the feedback wire and the conductive film are insulated from each other). The electrical signal on the conductive film 2 will not be transmitted to the feedback wire, and the feedback wire extends along the direction of current flow in the energized circuit. When there is an electrical signal on the conductive film 2, the conductive film 2 will vibrate under the action of the magnetic field, and the feedback wire on the conductive film 2 will vibrate together with the conductive film 2. Since the feedback wire is also located in the magnetic field, it will cut the magnetic flux lines along the vibration direction during the vibration process and generate an induced current in the feedback wire. By detecting the induced current, the vibration frequency of the conductive film 2 or the diaphragm can be accurately determined, and the frequency and sound intensity of the sound emitted by the diaphragm can be indirectly detected. In an embodiment provided in the present disclosure, the conductive film 2 includes at least one of gold, silver, copper, iron, aluminum, graphite, graphene, carbon fiber, polymer material and composite material. Different materials have different properties and timbres. By selecting different materials to make different conductive films 2, the needs of different users can be met.

Furthermore, in order to make the insulating film 1 have certain elasticity and insulating properties, and also to provide certain support for the conductive film 2, the insulating film 1 includes at least one of spandex material, silicone material, rubber material, polyester film, polyester fiber or other polymer materials. Other polymer materials with certain elasticity and insulation properties can also be applied to the insulating film 1 provided in an embodiment of the present disclosure.

In order to make the amplitude of the vibration of each conductive film 2 consistent, in an embodiment of the present disclosure, each conductive film 2 includes a plurality of segmented films, and the sizes of the plurality of segmented films are equal from one magnetic pole corresponding area 4 to another magnetic pole corresponding area 4, or the closer to the magnetic pole corresponding area 4, the larger the size of the segmented film. The plurality of segmented films all extends along the flow direction of the current in the energized circuit, and the plurality of segmented films are distributed at intervals from one magnetic pole corresponding area 4 to another magnetic pole corresponding area 4. Two sides of each conductive film 2 are all provided with the magnetic pole corresponding area 4, and the magnetic pole is placed in the magnetic pole corresponding area 4. According to the law of magnetic field strength of a magnet, the closer to the magnetic pole corresponding area 4, the stronger the magnetic field strength is, and the magnetic field strength in the middle location of the two magnetic pole corresponding areas 4 is the weakest. Since the current direction and magnitude in the conductive film 2 are the same, the conductive film 2 located at a location with a stronger magnetic field strength is subjected to a greater magnetic field force, that is, the vibration amplitude of the conductive film 2 is greater. By dividing the conductive film 2 into a plurality of segmented films along the length direction of the conductive film 2, the widths of different segmented films at different magnetic field strengths are different, and the weights of the segmented films with different widths are different. In addition to the magnetic field, the width design of the segmented film should also consider the deadweight (for example, the insulating film next to the conductive film is not affected by the magnetic field itself, and needs the conductive film to pull and vibrate, and its weight is considered deadweight), fixed end pulling and damping. The wider the segmented film located at a location with a stronger magnetic field strength, the heavier the weight; the smaller the segmented film located at a location with a weaker magnetic field strength, the lighter the weight. The greater the weight, the greater the inertia. When the conductive film 2 vibrates, the inertia factor can effectively offset the influence of the uneven magnetic field strength, thereby ensuring that the vibration amplitudes of each segmented film in the uneven magnetic field are roughly the same. At the same time, such a design is equivalent to increasing the length of the conductive film 2 in the magnetic field, which effectively improves the vibration efficiency of the diaphragm.

In one embodiment provided in the present disclosure, referring to FIG. 9, the conductive film 2 is divided into three segmented films, namely a first segmented film 21, a second segmented film 22 and a third segmented film 23, and the three segmented films are separated by insulating materials. The width of the first segmented film 21 and the third segmented film 23 is greater than that of the second segmented film 22, that is, the weight of the first segmented film 21 and the third segmented film 23 is greater than that of the second segmented film 22. When a magnet is provided in the magnetic pole corresponding area 4, the magnetic field strength at the position where the first segmented film 21 and the second segmented film 22 are located is relatively large, that is, the larger the amplitude of the vibration, the greater the inertia of the segmented film is by increasing the width of the segmented film. When the segmented film vibrates, it can offset part of the influence of the magnetic field force, thereby ensuring that the vibration amplitudes of different segmented films are roughly the same.

Further, referring to FIG. 10, the diaphragm includes one insulating film 1, the insulating film 1 includes a first surface 11 and a second surface 12 arranged opposite to each other, a plurality of segmented films is connected with the first surface 11, and an insulating structure is arranged between two adjacent segmented films. Each conductive film 2 is divided into three segmented films, wherein the first segmented film 21 and the second segmented film 22 are arranged on the first surface 11 of the insulating film 1, and the second segmented film 22 is arranged on the second surface 12 of the insulating film 1. The first segmented film 21 and the third segmented film 23 are arranged with an interval. By arranging different segmented films on different surfaces of the insulating film 1, the different segmented films can be effectively isolated from each other so that they will not affect each other.

Furthermore, the plurality of segmented films includes a plurality of first sub-segmented films and a plurality of second sub-segmented films. The plurality of first sub-segmented films is arranged on the first surface 11, and the plurality of second sub-segmented films is arranged on the second surface 12. The first sub-segmented films and the second sub-segmented films are arranged with an interval. In the embodiment of the present disclosure, the conductive film 2 can be divided into a plurality of sub-segment films of different widths or the same width, and adjacent sub-segment films are respectively arranged on different surfaces of the insulating film 1 so as to be separated from each other.

Furthermore, the insulating film 1 includes two insulating films 1 stacked together, and the plurality of segmented films is arranged between the two insulating films 1. In one embodiment of the present disclosure, the conductive film 2 is divided into a plurality of segmented films, and the different segmented films are approximately located on one same plane, and the different segmented films are spaced apart from each other. An upper surface and a lower surface of the segmented film are provided an insulating film 1 respectively. The upper and lower insulating films 1 can effectively prevent the conductive film 2 from contacting the air, thereby extending the service life of the conductive film 2.

Furthermore, in order to insulate different segmented films from each other, an insulating structure is provided between two adjacent segmented films.

An embodiment of the present disclosure also provides an audio device, which includes the above-mentioned diaphragm and also includes a plurality of magnet groups 5, the plurality of magnet groups 5 are distributed with an interval, each magnet group 5 includes a pair of magnets with the same magnetic poles facing each other, and an opposing gap is provided between each pair of magnets, and an energized gap is provided between two adjacent and opposing magnet groups 5 with opposite magnetic poles. The diaphragm is passed through in the opposing gap, each magnet group 5 is arranged corresponding to one magnetic pole corresponding area 4, and the conductive film 2 is arranged in the energized gap. Referring to FIG. 11, adjacent magnet groups 5 have different opposing magnetic poles, and the conductive film 2 on the diaphragm is located between adjacent magnet groups 5. By making two magnets opposite to each other and adjacent magnet groups 5 have different opposing magnetic poles, the magnetic field strength between the magnet groups 5 can be effectively enhanced.

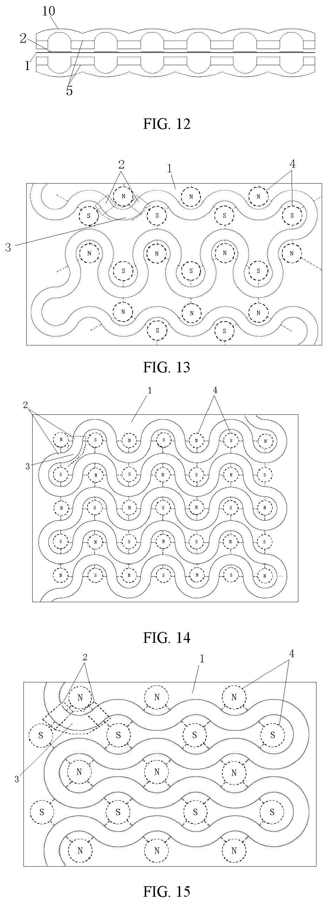

Further, referring to FIG. 12, the audio device further includes a plurality of magnetic conductors 10, and two adjacent and opposite magnet groups 5 with opposite magnetic poles are respectively connected with two ends of the magnetic conductors 10. The magnetic conductor 10 can effectively reduce the interference of the magnetic field generated by the opposite pole of the magnet group 5 with the magnetic field located between the two magnet groups 5, thereby reducing the field strength loss.

Furthermore, in one embodiment of the present disclosure, the audio device also includes a signal input circuit, a signal amplifier and a feedback circuit. The signal input circuit has an input end and an output end. The input end is used to receive an external input signal, and the output end is connected with the signal amplifier. The signal amplifier has an input port and an output port, the input port is connected with the output end, and the output port is connected with the energized circuit on the diaphragm. The feedback wire on the conductive film is connected with one end of the feedback circuit, and the other end of the feedback circuit is connected with the input port.

First, the input end of the signal input circuit receives an audio source signal, and then transmits it to the input port of the signal amplifier through the output end of the input circuit. After the sound source signal is processed by the signal amplifier, the output port on the signal amplifier will output a signal current with a certain frequency and intensity. The signal current then acts on the diaphragm. At this time, the conductive film 2 in the energized circuit will vibrate with a certain frequency and intensity, thereby emitting a sound with a certain frequency and intensity. During the vibration of the diaphragm, the feedback wire arranged on the conductive film will vibrate along with the conductive film 2. As the feedback wire vibrates, a corresponding induced current will be generated, which can accurately reflect the sound frequency and intensity emitted by the diaphragm. After receiving the signal of the induced current, the feedback circuit can compare the parameters of the sound source signal and the induced current, thereby completing the detection of the accuracy of the sound emitted by the diaphragm. The feedback circuit then adjusts the frequency and intensity of the signal current through the signal amplifier, making the sound emitted by the diaphragm more accurate.

In another embodiment of the present disclosure, the signal amplifier includes a feedback processing circuit. In addition to the signal amplification function, the signal amplifier also has the ability to process the sound source signal and the induced current. The output end of the input circuit is connected with the input port of the signal amplifier, while the output port of the signal amplifier is connected with the energized circuit on the diaphragm, and the feedback wire is connected with the input port of the signal amplifier. When the diaphragm vibrates, the induced current generated in the feedback wire is directly transmitted to the signal amplifier. After being processed by the feedback processing circuit in the signal amplifier, the signal amplifier will output a new signal current. Under the action of the new signal current, the sound emitted by the diaphragm is more accurate.

In a technical solution provided by the present disclosure, a feedback circuit or a signal amplifier can directly and in real time obtain detailed parameters of current (voltage) from the feedback wire, thereby indirectly judging the accuracy of the sound being played. In contrast, the existing common audio feedback system usually uses the parameters of the feedback current (voltage) obtained before the playback end to correct the signal current of the audio. The problem is that after the signal enters the playback end, the playback end also has signal interference or loss. Therefore, the feedback signal obtained by this type of audio before the playback end cannot actually accurately correct the signal current, and the sound emitted by the playback end is not accurate. In a technical solution provided in the present disclosure, the actual vibration state can be obtained when the diaphragm vibrates, and the sounding signal can be adjusted by the feedback current (voltage) parameters to make the sound source output more stable and accurate.

Referring to FIG. 13, an embodiment of the present disclosure provides a diaphragm, which includes one insulating film 1, a conductive film 2 and a connecting piece 3 arranged on the insulating film 1, and at the same time, the magnetic pole corresponding areas 4 on the diaphragm are arranged in a hexagonal shape, and the magnetic poles arranged in adjacent magnetic pole corresponding areas 4 are different. In FIG. 13, N or S in the magnetic pole corresponding area 4 represents that the opposing magnetic poles of a pair of mutually opposing magnets are N poles or S poles, respectively. The conductive film 2 is arranged between adjacent magnetic pole corresponding areas 4, and a plurality of conductive films 2 is connected in series through connecting pieces 3 to form a complete circuit. By applying current signal at two ends of the circuit, the force subjected by the conductive film 2 is in the same direction in the magnetic field, so that the circuit formed by the entire series connection vibrates with the same amplitude and direction at the same time. Referring to FIGs. 14 and 15, an embodiment of the present disclosure provides a diaphragm, which includes one insulating film 1, a conductive film 2 and a connecting piece 3 arranged on the insulating film 1, and at the same time, the magnetic pole corresponding areas 4 on the diaphragm are arranged in a quadrilateral, and the magnetic poles arranged in adjacent magnetic pole corresponding areas 4 are different. In FIGs. 14 and 15, N or S in the magnetic pole corresponding area 4 represents that the opposing magnetic poles of a pair of mutually opposing magnets are N poles or S poles, respectively. The conductive film 2 is arranged between adjacent magnetic pole corresponding regions 4, and a plurality of conductive films 2 is connected in series through the connecting pieces 3 to form a complete circuit. The series connection directions of the connecting pieces 3 in FIG. 14 and FIG. 15 are different. By applying current signal at two ends of the circuit, the force subjected by the conductive film 2 is in the same direction in the magnetic field, so that the circuit formed by the entire series connection vibrates with the same amplitude and direction at the same time.

In summary, in the technical solution provided in the embodiment of the present disclosure, at least one insulating film is connected with a plurality of conductive films arranged with an interval, and two sides of each conductive film are provided with a magnetic pole corresponding area respectively. In a specific embodiment, a magnet can be arranged in the magnetic pole corresponding area, and by reasonably arranging the area of each conductive film, since under a certain energy condition, the larger the area of the conductive film, the smaller the amplitude of the conductive film, each conductive film can also emit a low-frequency sound that meets the user's needs, so that the conductive film can cover the high, medium and low frequency spectrum. At the same time, by dividing each conductive film into a plurality of segmented films, the widths of different segmented films are different in different magnetic field strengths, so that the vibration amplitude of each segmented film is roughly the same, making the sounding of the diaphragm more accurate.

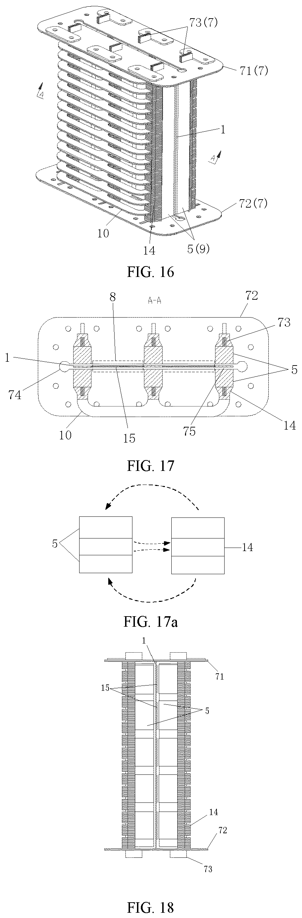

FIG. 16 is a schematic diagram of a three-dimensional structure of the sounding unit provided in an embodiment of the present disclosure, FIG. 17 is a schematic diagram of a cross-sectional structure in the A-A direction in FIG. 16, and FIG. 3 is a schematic diagram of a structure of a diaphragm provided in an embodiment of the present disclosure. Referring to FIGs. 16, 17, 17a and 3, a sounding unit is provided in an embodiment of the present disclosure, and the sounding unit includes: a mounting bracket 7, a plurality of magnet groups 5 and a diaphragm, and the mounting bracket 7 has a magnet mounting area and a diaphragm mounting area 16. The plurality of magnet groups 5 is arranged in the magnet mounting area and distributed with an interval. Each magnet group 5 includes a pair of magnets with the same poles facing each other, and an opposing gap is provided between each pair of magnets. A circuit placement area 8 is provided between two adjacent magnet groups 5 with opposite poles arranged opposite to each other. The diaphragm is arranged in the diaphragm mounting area 16, the diaphragm is provided with a plurality of magnetic pole corresponding areas 4 and an energized circuit 15, and the magnetic pole corresponding areas 4 are distributed on two sides of the diaphragm. The diaphragm is passed through the opposing gap, each magnet group 5 corresponds to one magnetic pole corresponding area 4, and the energized circuit 15 is arranged in the circuit placement area 8 (the area where the dotted box in the drawings is located is the circuit placement area 8, and the area size of the dotted box does not represent the actual area size of the circuit placement area 8, which is only used to indicate the positional relationship of the circuit placement area 8 relative to the diaphragm), so that the magnet group 5 can provide a stronger magnetic field for the energized circuit 15.

In the technical solution provided in the embodiment of the present disclosure, a plurality of magnet groups 5 and a diaphragm are arranged on a mounting bracket 7 and a circuit gap is provided between adjacent magnet groups 5, a plurality of magnetic pole corresponding areas 4 is provided on the diaphragm, each magnet group 5 all corresponds to one magnetic pole corresponding area 4, and two magnets in the magnet group 5 are respectively provided on two sides of the diaphragm. The energized circuit 15 on the diaphragm is arranged in the circuit gap, so that the energized circuit 15 with a larger unit area can be arranged in a stronger magnetic field. Under constant energy conditions, the larger the area of the energized circuit 15 in the working magnetic field, the smaller the amplitude of the conductive film, under the drive by the bass signal, the energized circuit 15 can also emit low-frequency sounds that meet user's needs, so that this sounding unit can cover the high, medium and low frequency spectrum.

The technical solution provided in the embodiments of the present disclosure is further described in detail below.

In one embodiment provided in the present disclosure, referring to FIGs. 16 to 20, the magnet group 5 is arranged along the height direction of the mounting bracket 7 to form a magnet column 9, and a plurality of magnet columns 9 is arranged with an interval along the width direction of the mounting bracket 7 (the plurality mentioned in the text includes 2 or more). In a specific embodiment, as shown in FIG. 16, only one magnet column 9 is provided along the width direction of the mounting bracket 7. Of course, in other embodiments of the present disclosure, a plurality of magnet columns 9 may also be included, and different magnet columns 9 are arranged with an interval along the width direction of the mounting bracket 7. When only one magnet column 9 is provided along the width direction of the mounting bracket 7, only one magnet group 5 is provided in the magnet column 9, and the opposing magnetic poles of two magnet groups 5 in adjacent magnet columns 9 are opposite. Or in another embodiment of the present disclosure, as shown in FIG. 18, a plurality of magnet groups 5 is provided in the magnet column 9, the plurality of magnet groups 5 is arranged with an interval along the height direction of the mounting bracket 7, the magnetic conductive material is provided between adjacent magnet groups 5, and a plurality of magnets is connected with the plurality of magnetic conductive materials to form a magnet column 9. In the same magnet column 9, the opposing magnetic poles of two adjacent magnet groups 5 are the same, and the opposing magnetic poles of two magnet groups 5 in adjacent magnet columns 9 are opposite. By using different installation methods of the magnet group 5, the sounding unit can be equipped with the diaphragm of different shapes.

Further, referring to FIGs. 1 and 17, in one embodiment of the present disclosure, the sounding unit includes three magnet columns 9, a circuit placement area 8 is provided in two adjacent magnet columns 9, two circuit placement areas 8 are provided in the three magnet columns 9, and the energized circuit 15 is arranged in the circuit placement area 8. However, in another embodiment of the present disclosure, the sounding unit includes two magnet columns 9, only one circuit placement area 8 is provided between two adjacent magnet columns 9, and the energized circuit 15 is arranged in the circuit placement area 8. Alternatively, the sounding unit includes three or more magnet columns 9, two adjacent magnet columns 9 are provided with a circuit placement area 8, and a plurality of circuit placement areas 8 is provided between a plurality of magnet columns 9. Such arrangement can meet the usage requirements of different users. For example, when a user needs a device with a small structure and a low volume, a sounding unit with only one circuit placement area 8 can be used. When a user needs a device with a higher volume, a sounding unit with a plurality of circuit placement areas 8 can be used.

Further, referring to FIG. 16 and FIG. 17, the sounding unit further includes a plurality of magnetic conductors 10, and the plurality of magnetic conductors 10 is arranged with an interval along the height direction of the mounting bracket 7, and a gap is provided between two adjacent magnetic conductors 10. The magnetic conductor 10 extends along the width direction of the mounting bracket 7 and spans across the plurality of magnet columns 9, and is respectively connected with the magnet groups 5 with opposite magnetic poles arranged opposite to each other in the adjacent magnet column 9. The magnetic conductor 10 can effectively reduce the magnetic field generated by the opposite pole of the magnet group 5 from interfering with the magnetic field located between the two magnet groups 5, thereby preventing the loss of magnetic field strength. The gap provided between two adjacent magnetic conductors 10 can effectively prevent the magnetic conductors 10 from blocking sound, but the gap does not affect the function of the magnetic conductors 10. In another embodiment of the present disclosure, a plurality of magnetic conductors 10 is an integrated structure, and a plurality of slot structures are provided on the surface thereof. The slot structures can effectively prevent the magnetic conductors 10 from blocking sound. Alternatively, the magnetic conductor 10 is provided with a plurality of through-hole structures.

In order to enable the magnetic conductor 10 to effectively conduct the magnetic field of the adjacent magnet column 9, referring to FIG. 16 and FIG. 17, a magnetic field conductor 14 is provided on one pole of the magnet column 9 facing away from the diaphragm, and the magnetic conductor 10 is connected with the magnetic field conductor 14. The magnetic field conductor 14 is arranged between the magnetic conductor 10 and the magnet column 9. The magnetic conductor 10 is formed by stacking a plurality of silicon steel sheets or a plurality of silicon steel blocks, or the magnetic conductor 10 is an integrated structure, and two sides of which are respectively connected with a plurality of magnetic conductors 10 and the magnet column 9. Through the action of the magnetic conductor 10, the magnetic field of the magnet column 9 can be effectively collected and conducted to the magnetic conductor 10. In one embodiment of the present disclosure, the magnetic field conductor 14 is formed by stacking a plurality of silicon steel sheets or a plurality of silicon steel blocks. The main function of the magnetic field conductor 14 is to conduct the magnetic field on the pole of the magnet column 9 facing away from the diaphragm to the magnetic conductor 10. Since adjacent magnetic conductors 10 are arranged with an interval, they cannot effectively collect and conduct the magnetic field. Therefore, the magnetic field conductor 14 is arranged between the magnet column 9 and the magnetic conductor 10, so that the magnetic field can be effectively conducted to the magnetic conductor 10.

In another embodiment of the present disclosure, referring to FIG. 17a, the dotted lines and arrows in the drawings roughly represent part of the magnetic flux lines generated by the magnet and their directions. A magnetic field conductor 14 is provided on one pole of the two magnets in each magnet group 5 that are opposite to each other, and can effectively gather the magnetic fields generated by the two magnets in the magnet group 5, thereby reducing the magnetic field loss of the magnet group 5. The diaphragm is arranged between the two magnet groups, and the magnetic field can be effectively concentrated in the space between the two magnet groups 5 through the magnetic field conductor 14, thereby ensuring that the diaphragm can be in a stronger magnetic field. For example, in one magnet group 5, two magnets provided therein are far apart. Since the magnetic fields will affect each other, the magnetic fields generated by the magnets facing each other will conduct to a certain loss. By adding magnetic field conducting members 14 to the two magnets respectively, the magnetic field can be effectively conducted, thereby effectively reducing the loss of the magnetic field.

Referring to FIGs. 16 and 17, in one embodiment provided in the present disclosure, the mounting bracket 7 includes an upper bracket plate 71, a lower bracket plate 72 and a plurality of pairs of vertical plates 73. The plurality of pairs of vertical plates 73 is arranged between the upper bracket plate 71 and the lower bracket plate 72 with an interval, and an accommodation gap 75 is provided between the two vertical plates 73 which are in pairs. The magnet column 9 is arranged in the accommodation gap 75. The magnet column 9 is fixedly connected with the vertical plate 73. The vertical plate 73 is used to provide a supporting force for the magnet column 9. Alternatively, the magnetic field conductor 14 is fixed to the vertical plate 73, the vertical plate 73 is used to provide support force for the magnetic field conductor 14, and the magnet column 9 is fixedly connected with the magnetic field conductor 14.

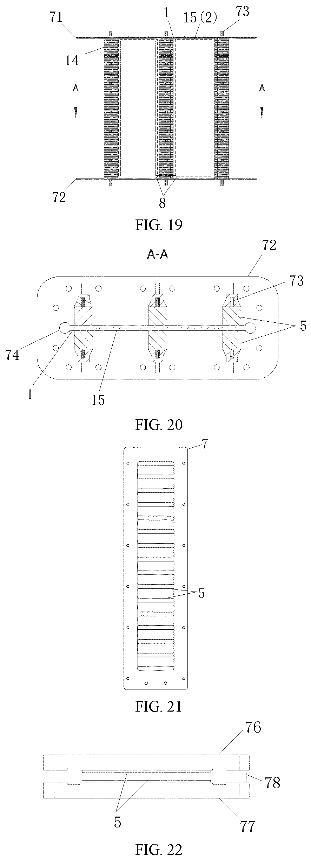

Furthermore, at least one of the upper bracket plate 71 and the lower bracket plate 72 is provided with a mounting hole 74, and the mounting hole 74 extends along the arrangement direction of the plurality of pairs of vertical plates 73 and corresponds to the accommodation gap 75. The arrangement of the mounting hole 74 can be used to fix the diaphragm, or to place the signal wire or power wire of the sounding unit. The side of the vertical plate 73 facing the accommodation gap 75 is a magnet mounting area, and the accommodation gap 75 and the mounting hole 74 form a diaphragm mounting area 16. By providing a diaphragm mounting area 16 with a certain range, the sounding unit can be adapted to the diaphragm of different shapes or structures. Referring to FIGs. 21 to 24, in one embodiment provided in the present disclosure, the mounting bracket 7 includes a first bracket plate 76 and a second bracket plate 77, wherein the first bracket plate 76 and the second bracket plate 77 are arranged opposite to each other, and a mounting gap 78 is provided between the first bracket plate 76 and the second bracket plate 77. The magnet group 5 is arranged in the mounting gap 78, and one magnet in each magnet group 5 is connected with the first bracket plate 76, and the other magnet is connected with the second bracket plate 77. There are many ways to connect the magnet to different bracket plates (the bracket plate represents the first bracket plate 76 and the second bracket plate 77). For example, the magnet can be fixed on the bracket plate by gluing, or a fixed limiting structure is provided on the bracket plate, and the magnet is installed in the fixed limiting structure.

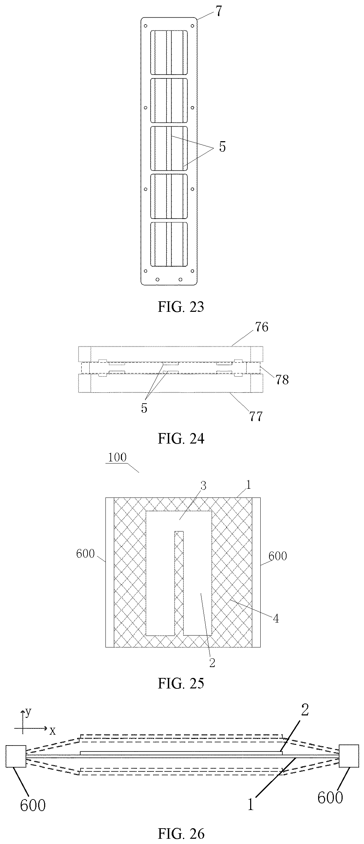

Furthermore, the mounting gap 78 can be flexibly set according to the actual size of the magnet group 5, and can be controlled by the connection structure between the first bracket plate 76 and the second bracket plate 77. For example, the size of the mounting gap 78 can be changed by adjusting the length of the bolt connecting the first bracket plate 76 and the second bracket plate 77. At the same time, the first bracket plate 76 and the second bracket plate 77 are provided with a sound-transmitting structure. Since the diaphragm is arranged in the circuit placement area 8 of the magnet group 5, when the diaphragm produces sound, the sound must pass through the bracket plate to be heard by the user. By providing a sound-transmitting structure on the bracket plate, the problem of sound being blocked can be effectively solved. Referring to FIG. 21, the bracket plate is a circular structure, and the square hole in the middle of the bracket plate is the sound-transmitting structure. Referring to FIG. 23, a plurality of square hole structures is arranged on the bracket plate, and the plurality of square hole structures is arranged with an interval along the length direction of the bracket plate. Meanwhile, in another embodiment of the present disclosure, the sound-transmitting structure is a plurality of hole structures opened on the bracket plate, and the hole structure may be a round hole, a square hole or a special-shaped hole.

Furthermore, there are many ways to arrange the magnet group 5 between the bracket plates. Referring to FIGs. 21 and 22, in one embodiment of the present disclosure, the length direction of each magnet group 5 is the same as the width direction of the bracket plate, and a plurality of magnet groups 5 is arranged with an interval along the length direction of the bracket plate. At the same time, in the width direction of the bracket plate, in addition to arranging one magnet group 5, a plurality of (2 or more) magnet groups 5 can also be arranged side by side. Referring to FIGs. 23 and 24, in another embodiment of the present disclosure, the length direction of each magnet group 5 is the same as the length direction of the bracket plate, and the plurality of magnet groups 5 is arranged with an interval along the width direction of the bracket plate. The magnet in each magnet group 5 may be a long strip magnet, or a long strip magnet with a longer length combined by a plurality of long strip magnet groups 5. By arranging the magnet group 5 in the mounting gap 78 in different ways, the sounding unit can be adapted to the diaphragm of different structures.

In one embodiment provided in the present disclosure, the sound-generating unit includes a diaphragm. Referring to FIG. 1 and FIG. 2, the diaphragm includes at least one insulating film 1, a plurality of (a plurality means 2 or more) conductive films 2 and a plurality of connecting pieces 3. The insulating film 1 is provided with a magnetic pole corresponding area 4 for placing a magnet. Each conductive film 2 is connected at least with one insulating film 1. The plurality of conductive films 2 is arranged with an interval, and two sides of each conductive film 2 are provided with a magnetic pole corresponding area 4. The plurality of conductive films 2 is connected in series via the plurality of connecting pieces 3 to form an energized circuit 15. The insulating film 1 not only has an insulating effect, but also has a certain elasticity. When the diaphragm vibrates, the insulating film 1 can stretch and shrink to a certain extent. In the technical solution provided in the embodiment of the present disclosure, at least one insulating film 1 is connected with a plurality of conductive films 2 arranged with an interval, and two sides of each conductive film 2 are provided with a magnetic pole corresponding area 4. In a specific embodiment, a magnet can be arranged in the magnetic pole corresponding area 4, and by reasonably arranging the area of each conductive film 2, since under the condition of constant energy, the larger the area of the conductive film 2, the smaller the amplitude of the conductive film, each conductive film 2 can also emit a low-frequency sound that meets the user's needs, so that the conductive film 2 can cover the high, medium and low frequency spectrum.

Furthermore, when the sounding unit has only one group of magnet column 9, in another embodiment of the present disclosure, the diaphragm includes one insulating film 1 and one conductive film 2, wherein the insulating film 1 is provided with four magnetic pole corresponding areas 4, and the four magnets in one group of magnet column 9 are respectively arranged in the corresponding four magnetic pole corresponding areas 4.

Referring to FIG. 4, in one embodiment provided in the present disclosure, the diaphragm includes two insulating films 1 stacked together, and a plurality of conductive films 2 is arranged between the two insulating films 1. The plurality of conductive films 2 is arranged in parallel, and two sides of each conductive film 2 are all provided with a magnetic pole corresponding areas 4. Two sides of the diaphragm are all distributed with the magnetic pole corresponding area 4, and adjacent conductive films 2 are arranged with an interval. The conductive film 2 is arranged between two layers of insulating films 1, which can effectively isolate the air from contacting the conductive film 2, thereby extending the service life of the conductive film 2 and increasing the structural strength of the diaphragm.

Furthermore, in order to achieve better insulation between adjacent conductive films 2, an insulating structure may be provided between two adjacent conductive films 2, and the thickness of the insulating structure is the same as that of the conductive film 2, and the insulating structure is also located between the two insulating films 1. In another embodiment of the present disclosure, two insulating films 1 may be directly bonded between two adjacent conductive films 2, which may also play an insulating role.

In an embodiment provided in the present disclosure, when the above-mentioned sounding unit includes a plurality of magnet columns 9, referring to FIG. 5, the diaphragm in the sounding unit includes a plurality of insulating films 1 and a plurality of conductive films 2, and the plurality of insulating films 1 and the plurality of conductive films 2 are connected in sequence with an interval. Two sides of one conductive film 2 are connected with one insulating film 1 respectively, and at the same time, two sides of one insulating film 1 are connected with two conductive films 2 respectively (except the insulating film 1 or the conductive film 2 at the two ends of the diaphragm).

Furthermore, in order to insulate different segmented films, an insulating structure is provided between two adjacent segmented films.

In one embodiment of the present disclosure, an audio device is also provided. The audio device includes: a device main body and the above-mentioned sounding unit arranged on the device main body. The device main body may be a housing of the sounding unit. For example, regarding a headphone device or a desktop audio, the device main body is the shell of the headphone or desktop audio, and the sounding unit is arranged inside the shell or in its cavity structure. Similarly, the device main body can also be a mounting bracket, such as regarding a large speaker, and the sounding unit is mounted on the mounting bracket.

Furthermore, in one embodiment of the present disclosure, the audio device also includes a signal input circuit, a signal amplifier and a feedback circuit. The signal input circuit has an input end and an output end. The input end is used to receive an external input signal, and the output end is connected with the signal amplifier. The signal amplifier has an input port and an output port. The input port is connected with the output end, and the output port is connected with the energized circuit 15 on the diaphragm. The feedback wire on the conductive film is connected with one end of the feedback circuit, and the other end of the feedback circuit is connected with the input port.

First, the input end of the signal input circuit receives an audio source signal, and then transmits it to the input port of the signal amplifier through the output end of the input circuit. After the sound source signal is processed by the signal amplifier, the output port on the signal amplifier will output a signal current with a certain frequency and intensity. The signal current then acts on the diaphragm. At this time, the conductive film 2 in the energized circuit 15 will vibrate with a certain frequency and intensity, thereby emitting a sound with a certain frequency and intensity. During the vibration of the diaphragm, the feedback wire arranged on the conductive film 2 will vibrate together with the conductive film 2. As the feedback wire vibrates, a corresponding induced current will be generated, which can accurately reflect the sound frequency and intensity emitted by the diaphragm. After receiving the signal of the induced current, the feedback circuit can compare the parameters of the sound source signal and the induced current, thereby completing the detection of the accuracy of the sound emitted by the diaphragm. The feedback circuit then adjusts the frequency and intensity of the signal current through the signal amplifier, making the sound emitted by the diaphragm more accurate.

In another embodiment of the present disclosure, the signal amplifier includes a feedback processing circuit. In addition to the signal amplification function, the signal amplifier also has the ability to process the sound source signal and the induced current. The output end of the input circuit is connected with the input port of the signal amplifier, while the output port of the signal amplifier is connected with the energized circuit 15 on the diaphragm, and the feedback wire is connected with the input port of the signal amplifier. When the diaphragm vibrates, the induced current generated in the feedback wire is directly transmitted to the signal amplifier. After being processed by the feedback processing circuit in the signal amplifier, the signal amplifier will output a new signal current. Under the action of the new signal current, the sound emitted by the diaphragm is more accurate.

In a technical solution provided by the present disclosure, a feedback circuit or a signal amplifier can directly and in real time obtain detailed parameters of current (voltage) from a feedback wire, thereby indirectly judging the accuracy of the sound being played. In contrast, the existing common audio feedback system usually uses the parameters of the feedback current (voltage) obtained before the playback end to correct the signal current of the audio. The problem is that after the signal enters the playback end, the playback end also has signal interference or loss. Therefore, the feedback signal obtained by this type of audio before the playback end cannot actually accurately correct the signal current, and the sound emitted by the playback end is not accurate. In a technical solution provided in the present disclosure, the actual vibration state can be obtained when the diaphragm vibrates, and the sounding signal can be adjusted by the feedback current (voltage) parameters to make the sound source output more stable and accurate.

To summarize, in the technical solution provided in the embodiment of the present disclosure, a plurality of magnet groups and a diaphragm are arranged on a mounting bracket and circuit gap is provided between adjacent magnet groups, a plurality of magnetic pole corresponding areas is provided on the diaphragm, each magnet group corresponds to one magnetic pole corresponding area, and the energized circuit on the diaphragm is arranged in the circuit gap, thereby enabling an energized circuit with relative larger unit area to be arranged in a stronger magnetic field. Since under a certain energy condition, the larger the area of the conductive film, the smaller the amplitude of the conductive film, under the drive of the bass signal, the energized circuit can also emit low-frequency sound that meets user's needs, so that this sounding unit can cover the high, medium and low frequency spectrum. At the same time, by dividing each conductive film into a plurality of segmented films, the widths of different segmented films are different in different magnetic field intensities, so that the vibration amplitude of each segmented film is roughly the same, making the sounding of the diaphragm more accurate. A feedback wire is provided on the conductive circuit, which can obtain the actual vibration state when the diaphragm vibrates in real time, and then adjust the sounding signal through the parameters of the feedback current (voltage), so as to make the sound source output more stable and accurate.

FIG. 25 is a schematic diagram of a planar structure of a diaphragm provided in an embodiment of the present disclosure, and FIG. 26 is a schematic diagram of a vibration state of a diaphragm provided in an embodiment of the present disclosure, see FIG. 25 and FIG. 26.

In one embodiment of the present disclosure, a diaphragm is provided, comprising: at least one insulating film 1, a plurality of conductive films 2 and a plurality of connecting pieces 3. The insulating film 1 is an open mesh or a non-open film made of a viscoelastic material. The insulating film 1 has a connection end, on which a viscoelastic connection structure 600 is provided. A magnetic pole corresponding region 4 is provided on the insulating film 1. Each conductive film 2 is at least connected with one insulating film 1, the plurality of conductive films 2 are arranged with an interval, and two side of each conductive film 2 are provided with the magnetic pole corresponding region 4 respectively. The plurality of conductive films 2 is connected in series via a plurality of connecting pieces 3 to form an energized circuit.

When in use, the diaphragm is fixedly connected by the viscoelastic connection structure 600, such as fixedly connected with the shell of the speaker, and a magnet 200 is correspondingly provided at the magnetic pole corresponding area 4 of the diaphragm, so that the diaphragm is in the magnetic field. When the energized circuit is energized, the diaphragm vibrates in conjunction with the magnetic field of the magnet 200. When the diaphragm vibrates, the vibration energy is transmitted to the viscoelastic connection structure 600. Part of the energy is consumed in the internal energy consumption of the viscoelastic deformation of the viscoelastic connection structure 600 and released in the form of heat, and another part of the energy is stored in the viscoelastic connection structure 600 as elasticity. In this way, the energy transmitted from the diaphragm is absorbed by the viscoelastic connection structure 600, and the energy rebounding back to the diaphragm is very small or even disappears.

In the technical solution provided in the embodiment of the present disclosure, a viscoelastic connection structure 600 is provided on the insulating film 1, and the insulating film 1 is fixedly connected through the viscoelastic connection structure 600. When the diaphragm vibrates, the viscoelastic connection structure 600 can absorb the vibration energy transmitted from the diaphragm, thereby reducing the negative impact of the rebound on the vibration of the diaphragm itself. The viscoelastic connection structure and the insulating film (mesh) provide tension and displacement in the vibration direction for the diaphragm, thereby increasing the amplitude of the diaphragm and reducing the bass loss. At the same time, the delay in the time domain of sound generation is reduced, so as to better show the state of the original sound when the sound being played.

In the embodiment of the present disclosure, to ensure the elastic performance of the insulating film 1, the implementation of the insulating film 1 includes but is not limited to one of a spandex open mesh, a silicone film, a rubber film, a polyester film, and a polyester fiber film with viscoelastic properties. The implementation of the viscoelastic connection structure 600 includes but is not limited to viscoelastic glue. The conductive film 2 includes but is not limited to being made of the following materials, and the conductive film 2 includes one of gold, silver, copper, iron, aluminum, graphite, graphene, carbon fiber, polymer material and composite material. Different materials have different properties and timbres. By selecting different materials to make different conductive films 2, the needs of different users can be met. For example, the conductive film 2 on the diaphragm can be made of a metal foil film, such as an aluminum foil film. The conductive film 2 can be connected with the insulating film 1 by gluing, or a plurality of conductive films 2 can be etched on the insulating film 1 by etching. The insulating film 1 is made of an open spandex mesh or a non-open silicone film, and one end of the insulating film 1 connected with the fixed structure uses viscoelastic glue to absorb energy.

Referring to FIG. 25, it should be noted that the aluminum foil films shown in the solution shown in FIG. 25 are shown as two pieces, which is only an example. In fact, the number can be from one piece to countless pieces, which is not limited to this. The aluminum foil films are connected with each other through the connecting piece, so that a plurality of conductive films 2 is connected in series. The insulating film 1 adopts a spandex open mesh or a non-open silicone film. The open mesh described here corresponds to the non-open structure, which refers to whether the two opposite sides of the insulating film 1 are closed structures. The open mesh means that the two sides are non-closed meshes, and the non-open structure means that the two sides are closed film structures. The spandex and silicone film here are only examples. In the embodiment of the present disclosure, the manufacturing materials of the insulating film 1 also include other materials with properties similar to spandex. The design of the open mesh can be a single horizontal line arrangement, or a single vertical line arrangement, or a horizontally and vertically interwoven mesh structure. The density of the horizontal and vertical lines can be designed to adjust the weight of the open mesh per unit area. The open mesh and the aluminum foil film are fully bonded together by adhesive. The spandex open mesh and the non-open silicone film have good elasticity, which can not only provide the tension required for the diaphragm to vibrate, see FIG. 26, but also provide displacement in the y-axis direction in the direction of the diaphragm vibration. In FIG. 26, a vibration coordinate system is established with the direction of diaphragm vibration as the y-axis and the length direction of the diaphragm as the x-axis. The diaphragm vibrates along the y-axis in the vibration coordinate system. The dotted line in FIG. 26 shows the schematic position of the diaphragm when it vibrates.

Since the conductive film 2 will deform when vibrating, it will produce abnormal noise. In the embodiment of the present disclosure, the abnormal noise can be eliminated by weakening the strength of the entire conductive film 2. One possible implementation is to provide a plurality of weakening structures on the conductive film 2 for reducing the strength of the conductive film 2. Since the strength of the weakening structure is lower than the strength of other areas of the conductive film 2, when the conductive film 2 vibrates and deforms, the conductive film 2 will first deform through the weakening structure, which will effectively eliminate the abnormal sound. There are many ways to implement the weakening structure, including but not limited to a pleated structure, or a hole structure, or a combination of the two.

Still taking the conductive film 2 as an aluminum foil film as an example, for example, some work is done to weaken the strength of the aluminum foil film, such as rubbing, bending, and unfolding the aluminum foil film, repeatedly several times, so that it produces slight metal fatigue and forms a wrinkled structure, so that the large area of the aluminum foil film will become a relatively weak connection of the small unit aluminum foil film. When vibration causes deformation, the aluminum foil film will deform first at the weak connection, which will effectively eliminate abnormal noise. Alternatively, in order to weaken the film structure, small holes can be punched in the aluminum foil or it can be chemically corroded. For example, copper sulfate can be used to corrode the aluminum foil to produce tiny holes, etc., which can eliminate the abnormal sound emitted by the aluminum foil itself when it vibrates. Of course, this is only an operation for the aluminum foil film. Correspondingly, when the conductive film 2 is made of other materials, corresponding operations can also be performed on any other metal foil film to eliminate the abnormal sound itself.

Since the vibration of the conductive film 2 drives the insulating film 1 to vibrate together, if the insulating film 1 is directly fixed to the fixed structure, the vibration at the fixed point will return in the direction it came from, causing the insulating film 1 to participate in the vibration of the conductive film 2 itself with the vibration of the previous wave, that is, to produce a time domain difference, which affects the vibration of the conductive film 2. Therefore, a viscoelastic connection structure 600, such as viscoelastic glue, is provided on the connection end of the insulating film 1, and the insulating film 1 is fixed to the fixed structure (such as the shell of the sound box) by the viscoelastic glue. When the diaphragm vibrates, the vibration energy is transmitted to the viscoelastic connection structure 600. Part of the energy is consumed in the internal energy dissipation of the viscoelastic deformation of the viscoelastic connection structure 600 and released in the form of heat, and another part of the energy is stored in the viscoelastic connection structure 600 as elasticity. In this way, the energy transmitted from the diaphragm is absorbed by the viscoelastic connection structure 600, and the energy that bounces back to the diaphragm is very small or even disappears. Of course, in some feasible embodiments of the present disclosure, the viscoelastic connection structure 600 may also be provided on the housing of the audio device, and the housing may be connected with the diaphragm via the viscoelastic connection structure 600, which may also achieve the above-mentioned effect.

Referring to FIGs. 1 and 2, in some achievable embodiments of the present disclosure, the connecting piece 3 may be implemented in a variety of ways according to different requirements. One achievable way of the connecting piece 3 is that the connecting piece 3 includes a connecting film arranged on the insulating film 1. The material of the connecting film can be the same as that of the conductive film 2, or can be different, as long as the conductive function can be achieved. Another possible implementation of the connecting piece 3 is that the connecting piece 3 includes but is not limited to a conductive wire. The conductive wire may be provided outside the insulating film 1 or on the insulating film 1. The diaphragm 100 will vibrate only when it is in a magnetic field and current flows through the conductive film 2 on the diaphragm 100. In order to allow each conductive film 2 to have current flow through it in a preset direction, a plurality of conductive films 2 is connected in series by arranging a connecting piece 3, thereby completing the direction of current flow. Since the adjacent conductive films 2 are in magnetic fields with different directions, in order to make the vibration directions of the plurality of conductive films 2 the same at the same time, the current directions in the adjacent conductive films 2 are different. By the connection in series of the connecting pieces 3, the directions of the currents flowing through the adjacent conductive films 2 can be made different.

In the embodiment of the present disclosure, in order to simplify the structure of the diaphragm, referring to FIGs. 25, 26, 1, and 2, when the connecting piece 3 is a connecting film, the connecting piece 3 can be arranged on the insulating film 1, and at the same time, the connecting piece 3 spans the magnetic pole corresponding area 4 to realize the connection between the two conductive films 2, and makes the flow direction of the current in the connecting piece 3 the same as or opposite to the direction of the magnetic field (the flow direction of the current is not perpendicular to the magnetic field), so that when current passes through the connecting piece 3, the connecting piece 3 does not generate force with the magnetic field and vibrate. Furthermore, in order to reduce the weight of the diaphragm, referring to FIG. 1, the connecting piece 3 can be a conductive wire, one end of which is connected with one end of one conductive film 2, and the other end is simultaneously connected with one end of another conductive film 2, so that each conductive film 2 is respectively connected in series with the conductive films 2 adjacent to it on two sides. The conductive wire is arranged on the outside of the diaphragm and will not increase the weight of the diaphragm.

The implementation method of the diaphragm provided in the embodiments of the present disclosure is further described in detail below.

In the embodiment of the present disclosure, according to different requirements, there are a plurality of ways to implement the diaphragm, referring to FIGs. 3 and 4, one insulating film 1 is provided, referring to FIG. 5, two insulating films 1 may also be provided, referring to FIGs. 6, 7, and 8, more than two insulating films 1 may also be provided, and the outermost insulating film 1 is provided with a viscoelastic connection structure 600. Under different configurations of the insulating film 1, the connection modes of the conductive film 2 and the insulating film 1 are also different. They are introduced below one by one.

Referring to FIG. 5, in an achievable embodiment provided in the present disclosure, the insulating film 1 includes two stacked insulating films 1, and the plurality of conductive films 2 is arranged between the two insulating films 1. The plurality of conductive films 2 is arranged with an interval and connected in series through a plurality of connecting pieces 3. Two sides of each conductive film 2 are all provided with the magnetic pole corresponding area 4 are provided on. The conductive film 2 is arranged between two layers of insulating films 1, which can effectively isolate the air from contacting the conductive film 2, extend the service life of the conductive film 2, and at the same time increase the structural strength of the diaphragm. Furthermore, in order to better isolate adjacent conductive films 2, an insulating structure is provided between two adjacent conductive films 2. The insulating structure can be made of the same material as the insulating film 1.

Referring to FIGs. 6, 7, and 8, more than two insulating films 1 are provided, and the plurality of insulating films 1 is sequentially connected with the plurality of conductive films 2 with an interval. Two sides of one conductive film 2 are connected with one insulating film 1 respectively, and two sides of one insulating film 1 are connected with two conductive films 2 respectively, thereby forming a diaphragm with an integral structure. Of course, the insulating film 1 located at the edge of the diaphragm is connected with only one conductive film 2, and the insulating film 1 located at the edge of the diaphragm is used to connect to the housing of the audio device.

When more than two insulating films 1 are provided, one connection method of the conductive film 2 can be seen by FIG. 6. The insulating film 1 includes a first surface 11 and a second surface 12 arranged opposite to each other, and a side surface arranged between the first surface 11 and the second surface 12. The plurality of conductive films 2 is all connected with the first surface 11. Two ends of the conductive film 2 are connected with the two insulating films 1, respectively. Two ends of the first surface 11 of the insulating film 1 are connected with the two conductive films 2, respectively. The plurality of conductive films 2 are approximately on one same plane, and the plurality of insulating films 1 are also approximately on one same plane. The plane where the conductive films 2 are located is different from the plane where the insulating films 1 are located, and said two planes are parallel to each other.

Referring to FIG. 7, the insulating film 1 includes a first surface 11 and a second surface 12 arranged opposite to each other, and a side surface arranged between the first surface 11 and the second surface 12. The plurality of conductive films 2 is all connected with the side surface. The diaphragm 100 is a one-layer structure, and the plurality of conductive films 2 and the plurality of insulating films 1 are substantially on one same plane. Two sides of one conductive film 2 are connected with two insulating films 1 respectively, and similarly, two sides of one insulating film 1 are connected with two conductive films 2 respectively.

Referring to FIG. 8, the insulating film 1 includes a first surface 11 and a second surface 12 arranged opposite to each other. Two sides of the conductive film 2 are provided with an insulating film 1. The conductive film 2 is connected with the first surface 11 of one insulating film 1 and with the second surface 12 of another insulating film 1. The conductive film 2 is located between the two insulating films 1 and is respectively connected with the two insulating films 1, that is, the upper surface of one end of the conductive film 2 is connected with the second surface 12 of one insulating film 1, and the lower surface of one end of the conductive film 2 is connected with the first surface 11 of another insulating film 1.

Furthermore, in order to accurately detect the vibration frequency and amplitude of the diaphragm, detecting the vibration frequency and amplitude of the diaphragm is also equivalent to detecting the vibration frequency and sound intensity of the emitted sound. In a possible embodiment of the present disclosure, a feedback wire is provided on the conductive film 2, and the feedback wire extends along the direction of current flow in the energized circuit. The feedback wire and the conductive film 2 are circuit-isolated from each other (circuit isolation means that the feedback wire and the conductive film 2 are insulated from each other to avoid current interference between the two). The electrical signal on the conductive film 2 will not be transmitted to the feedback wire. When there is an electrical signal on the conductive film 2, the conductive film 2 will vibrate under the action of the magnetic field, and the feedback wire on the conductive film 2 will vibrate together with the conductive film 2. Since the feedback wire is also located in the magnetic field, it will cut the magnetic flux lines along the vibration direction during the vibration process and generate an induced current (voltage) in the feedback wire. By detecting the induced current (voltage), the vibration frequency of the diaphragm can be accurately determined, thereby detecting the vibration frequency and intensity of the sound emitted by the diaphragm. After receiving the induced current signal, the feedback circuit can compare the parameters of the sound source signal and the induced current (voltage), thereby completing the detection of the accuracy of the sound emitted by the diaphragm. The feedback circuit then adjusts the intensity of the signal current through the signal amplifier, making the sound emitted by the diaphragm more accurate.

In order to make the vibration amplitude at each position of each conductive film 2 as consistent as possible, referring to FIG. 4 and FIG. 3, in some achievable embodiments of the present disclosure, each conductive film 2 includes a plurality of segmented films, and the plurality of segmented films all extends along the flow direction of current in the energized circuit. From one magnetic pole corresponding area 4 to another magnetic pole corresponding area 4, a plurality of segmented films is distributed with an interval. Two sides of each conductive film 2 are all provided with the magnetic pole corresponding area 4. The magnet is arranged corresponding to the magnetic pole corresponding area 4. According to the law of the magnetic field strength of the magnet, the closer to the magnetic pole corresponding area 4, the stronger the magnetic field strength is, and the magnetic field strength in the middle position between the two magnetic pole corresponding areas 4 is the weakest. Since the current direction and magnitude in the conductive film 2 are the same, the conductive film 2 located at a location with a stronger magnetic field strength is subjected to a greater magnetic field force, that is, the vibration amplitude of the conductive film 2 is greater. By dividing the conductive film 2 into a plurality of segmented films and then arranging the widths of different segmented films, the weight of the segmented films is changed, thereby adjusting the amplitude thereof in the magnetic field.

For example, when the influence of the magnetic field strength is not very strong, the sizes of the plurality of segmented films are equal from one magnetic pole corresponding region 4 to another magnetic pole corresponding region 4. When the magnetic field strength has a greater influence, the closer to the magnetic pole corresponding area 4, the larger the size of the segmented film. The magnetic field intensity closer to the magnetic pole corresponding area 4 can be defined as a high field intensity area, and the magnetic field intensity in the middle of the two magnetic pole corresponding areas 4 can be defined as a weak field intensity area. The segmented film located in the high field strength area has a large width and a large weight, while the segmented film located in the weak field strength area has a small width and a small weight. That is, the widths of different segmented films at different magnetic field strengths are different, and the weights of segmented films of different widths are different. In addition to the magnetic field, the width design of the segmented film should also consider the deadweight (deadweight refers to the weight of an object that needs to be pulled by the conductive film 2 to vibrate. The deadweight of the diaphragm refers to the weight of the insulating film 1. The insulating film 1 itself is not affected by the magnetic field and needs to be pulled by the conductive film 2 to vibrate. Its weight is considered the deadweight), fixed end pulling and damping. The wider the segmented film located at a location with a stronger magnetic field strength, the heavier the weight; the smaller the segmented film located at a location with a weaker magnetic field strength, the lighter the weight. The greater the weight, the greater the inertia. When the conductive film 2 vibrates, the inertia factor can effectively offset the influence of the uneven magnetic field strength, thereby ensuring that the vibration amplitudes of each segmented film in the uneven magnetic field are roughly the same. At the same time, such a design is equivalent to increasing the length of the conductive film 2 in the magnetic field, which effectively improves the vibration efficiency of the diaphragm 100.

In the embodiment of the present disclosure, there are a plurality of ways to arrange the segmented film according to different requirements. One achievable way is shown by FIG. 3. One insulating film 1 is provided, and the insulating film 1 includes a first surface 11 and a second surface 12 that are arranged opposite to each other. The plurality of segmented films is all connected with the first surface 11, and an insulating structure is provided between two adjacent segmented films. Taking three segmented films being provided as an example, the conductive film 2 is divided into three segmented films which are spaced apart in sequence, namely a first segmented film 21, a second segmented film 22 and a third segmented film 23. The three segmented films are separated by insulating materials. The width of the first segmented film 21 and the third segmented film 23 is greater than that of the second segmented film 22, that is, the weight of the first segmented film 21 and the third segmented film 23 is greater than that of the second segmented film 22. When a magnet is provided in the magnetic pole corresponding area 4, the magnetic field strength at the position where the first segmented film 21 and the second segmented film 22 are located is relatively large, so that the vibration amplitude of the first segmented film 21 and the second segmented film 22 is relatively large. By increasing the width of the first segmented film 21 and the second segmented film 22, the weight of the first segmented film 21 and the second segmented film 22 is increased. When the first segmented film 21 and the second segmented film 22 vibrate, they can offset part of the influence of the magnetic field force and relatively reduce the vibration amplitude. The magnetic field strength at the position of the second segmented film 22 is smaller, so that the vibration amplitude of the second segmented film 22 is smaller. By reducing the width of the second segmented film 22, the weight of the second segmented film 22 is lighter and the vibration amplitude is relatively increased, thereby ensuring that the vibration amplitudes of different segmented films are roughly the same.

Another arrangement of the segmented film is as shown in FIG. 4. One insulating film 1 is provided. The insulating film 1 includes a first surface 11 and a second surface 12 that are arranged opposite to each other. The plurality of segmented films includes a plurality of first sub-segmented films and a plurality of second sub-segmented films. The plurality of first sub-segmented films is arranged on the first surface 11, and the plurality of second sub-segmented films is arranged on the second surface 12. The first sub-segmented film and the second sub-segmented film are arranged with an interval. Still taking the example of three segmented films, including two first sub-segmented films and one second sub-segmented film, the two separated first sub-segmented films are respectively the first segmented film 21 and the third segmented film 23, the second sub-segmented film is the second segmented film 22, the first segmented film 21 and the third segment are respectively arranged on the first surface 11 of the insulating film 1, and the second segmented film 22 is arranged on the second surface 12 of the insulating film 1. By arranging different segmented films on different surfaces of the insulating film 1, the different segmented films can be effectively isolated from each other so that they will not affect each other. Furthermore, another arrangement of the segmented film is that the insulating film 1 includes two stacked insulating films, and a plurality of segmented films are arranged between the two insulating films 1. The conductive film 2 is divided into a plurality of segmented films, and different segmented films are approximately located on one same plane, and the different segmented films are spaced apart from each other. The insulating film 1 is connected with the upper surface and the lower surface of the segmented film respectively. The upper and lower insulating films 1 can effectively prevent the conductive film 2 from contacting with the air, thereby extending the service life of the conductive film 2. In order to insulate different segmented films, an insulating structure is provided between two adjacent segmented films.

Based on the diaphragm provided in the embodiment of the present disclosure, accordingly, the embodiment of the present disclosure also provides an audio device, including: the above-mentioned diaphragm and a plurality of magnets. The plurality of magnets is respectively arranged corresponding to the magnetic pole corresponding areas 4, and the energized circuit is located between two adjacent magnets with opposite magnetic poles facing the diaphragm. The audio device includes but is not limited to headphones, amplifiers, speakers, etc. The implementation method of the diaphragm can refer to and draw on the contents in the above embodiments, which will not be described in detail here.

When in use, the diaphragm is fixedly connected with the shell of the audio device through the viscoelastic connection structure 600. Magnet is provided at the magnetic pole corresponding area 4 of the diaphragm, so that the diaphragm is in the magnetic field. When the energized circuit is energized, the diaphragm vibrates in conjunction with the magnetic field of the magnet. When the diaphragm vibrates, the vibration energy is transmitted to the viscoelastic connection structure. Part of the energy is consumed in the internal energy consumption of the viscoelastic deformation of the viscoelastic connection structure and released in the form of heat, and another part of the energy is stored in the viscoelastic connection structure as elasticity. In this way, the energy transmitted from the diaphragm is absorbed by the viscoelastic connection structure, and the energy rebounding back to the diaphragm is very small or even disappears.

In the embodiment of the present disclosure, the diaphragm can be used in a vertical state, as shown in FIG. 26, and the diaphragm can vibrate back and forth along the y-axis direction to generate sound. Furthermore, in order to make the sound effect of the diaphragm better, one possible implementation of the diaphragm is that the diaphragm is in a first structure, and the first structure has at least one sounding cavity. The plurality of magnets is arranged in a second structure that matches the first structure. A plurality of magnets is respectively arranged corresponding to the magnetic pole corresponding area 4, and the energized circuit is located between two adjacent magnets with opposite magnetic poles facing the diaphragm.

The diaphragm can also be used in other shapes. For example, take the diaphragm in a cylindrical structure as an example, that is, the first structure is a cylindrical structure, the space enclosed by the cylindrical structure is the sounding cavity, and along the circumferential direction of the cylindrical structure, magnetic pole corresponding area and energized circuit are arranged with an interval on the diaphragm. The magnet is a bar magnet, and a plurality of bar magnets is arranged with an interval along the circumferential direction of the cylindrical structure and respectively correspond to the magnetic pole corresponding areas on the diaphragm. The magnetic poles of two adjacent magnets facing the diaphragm are opposite.

When in use, the diaphragm and the magnet form a sounding unit, which is arranged in the housing of the audio device. Two axial ends of the cylindrical structure can be in three states. One state is that the two axial ends of the cylindrical structure are closed, that is, the opening of the sounding cavity is in a closed state, which can also be called the interior of the sounding cavity is completely closed. Under this structure, the diaphragm relies on the outside of the sounding cavity to make sound, and the diaphragm is annularly closed, which is equivalent to having only one side. The sound waves front and behind the diaphragm will not offset each other, and the bass will not be lost. The full range of sound can be covered with a smaller volume and one single sounding element.

Another state is that the circumferential outer periphery of the cylindrical structure is closed and the two axial ends are open, that is, the opening of the sounding cavity is in an open state and the outer periphery of the sounding cavity is closed. Under this structure, the diaphragm relies on the inside of the sounding cavity to make sound, and the energized circuit on the diaphragm is energized, cooperating with the magnetic field generated by a plurality of magnets, so that the diaphragm can vibrate along the radial direction of the cylindrical structure, so that the internal air of the sounding cavity is squeezed and vibrated to produce sound waves, and the sound waves are transmitted from the axial direction of the cylindrical structure. Since the periphery of the diaphragm is closed, the sound will produce a superimposed effect inside the sounding cavity. The sound is not only offset by the front and behind, but it is also strengthened and emitted from the hollow part of the sounding cavity. There is no physical sound source in the hollow part of the sounding cavity, so it is more like a virtual sound source, thus obtaining a sound source in which both the bass and treble are strengthened.

Still another state is that the circumferential outer periphery and two axial ends of the cylindrical structure are not closed. Under this structure, the diaphragm not only relies on the inside of the sounding cavity to make sound, but also relies on the outside of the sounding cavity to make sound, avoiding the offset of the sound in front and behind the diaphragm, and being strengthened at the same time to reduce the loss of bass in front and behind the diaphragm. In the technical solution provided in the embodiment of the present disclosure, when the energized diaphragm vibrates under the action of the magnetic field of the magnet, it vibrates into and out of the sounding cavity, and the sound waves front and behind the diaphragm will not offset each other, so there will be no loss of bass, and the full range of sound can be covered with a smaller volume and one single sounding element.

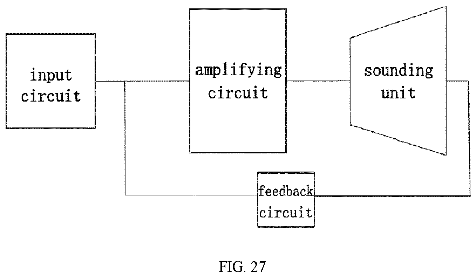

Furthermore, in a possible embodiment of the present disclosure, referring to FIG. 27, the audio device further includes a signal input circuit, a signal amplifier and a feedback circuit. The signal input circuit is connected with the signal amplifier, and the signal amplifier is connected with the audio device. The feedback circuit is respectively connected with the feedback wire on the conductive film 2 in the audio device and the signal amplifier, and is used to feed back the vibration frequency of the diaphragm 100 in the audio device to the signal amplifier. After the input end of the input circuit receives an audio source signal, the audio source signal is converted into a corresponding first electrical signal, and the first electrical signal is transmitted to the input port of the signal amplifier through the output end of the input circuit. After the first electrical signal is amplified, filtered, and processed by the signal amplifier, the output port on the signal amplifier will output a second electrical signal with a certain frequency and intensity to the audio device. The second electrical signal acts on the diaphragm 100 through the energized circuit of the diaphragm 100. At this time, the conductive film 2 in the energized circuit is energized, and the conductive film 2 will vibrate with a certain frequency and intensity in the magnetic field, thereby emitting a sound with a certain frequency and intensity.

When the diaphragm 100 vibrates, the feedback wire arranged on the conductive film 2 will vibrate together with the conductive film 2. Since the feedback wire generates a corresponding induced current during the vibration process, the induced current can accurately reflect the sound frequency and sound intensity emitted by the diaphragm 100. After receiving the signal of the induced current, the feedback circuit can compare the first electrical signal converted from the sound source signal with the induced current, thereby completing the detection of the accuracy of the sound emitted by the diaphragm 100. Then the feedback circuit feeds back the detection result to the signal amplifier, and the signal amplifier adjusts the second electrical signal according to the detection result, so that the sound emitted by the diaphragm 100 is more accurate.

In another embodiment of the present disclosure, the signal amplifier includes a feedback processing circuit. In addition to the signal amplification function, the signal amplifier also has the ability to process the sound source signal and the induced current. The output end of the input circuit is connected with the input port of the signal amplifier while the output port of the signal amplifier is connected with the energized circuit on the diaphragm 100, and the feedback wire is connected with the input port of the signal amplifier. When the diaphragm 100 vibrates, the induced current generated in the feedback wire is directly transmitted to the signal amplifier. After being processed by the feedback processing circuit in the signal amplifier, the signal amplifier will output a new signal current. Under the action of the new signal current, the sound emitted by the diaphragm 100 is more accurate.

In a technical solution provided by the present disclosure, a feedback circuit or a signal amplifier can directly and in real time obtain detailed parameters of current (voltage) from a feedback wire, thereby indirectly judging the accuracy of the sound being played. In contrast, the existing common audio feedback system usually uses the parameters of the feedback current (voltage) obtained before the playback end to correct the signal current of the audio. The problem is that after the signal enters the playback end, the playback end also has signal interference or loss. Therefore, the feedback signal obtained by this type of audio before the playback end cannot actually accurately correct the signal current, and the sound emitted by the playback end is not accurate. In a technical solution provided in the present disclosure, the actual vibration state can be obtained when the diaphragm 100 vibrates, and the sounding signal can be adjusted by the feedback current (voltage) parameters to make the sound source output more stable and accurate.

Furthermore, in order to make the sounding unit formed by the diaphragm 100 and the magnet more integrated, referring to FIGs. 16 to 24, in an embodiment provided in the present disclosure, the diaphragm 100 and the magnet are both integrated and mounted on a mounting bracket 7. The diaphragm 100 and the magnet can form a whole through the mounting bracket 7, thereby improving the modularity of the sounding unit and facilitating the assembly of the sounding unit.

One possible implementation of the mounting bracket 7 is that the mounting bracket 7 includes a first bracket plate 76 and a second bracket plate 77, wherein the first bracket plate 76 and the second bracket plate 77 are arranged opposite to each other, and a mounting gap 78 is provided between the first bracket plate 76 and the second bracket plate 77. The magnet group 5 is arranged in the mounting gap 78, and one magnet in each magnet group 5 is connected with the first bracket plate 76, and another magnet 200 of which is connected with the second bracket plate 77. The magnet 200 can be connected with different bracket plates (the bracket plates represent the first bracket plate 76 and the second bracket plate 77) in a variety of ways. For example, the magnet 200 can be fixed on the bracket plate by gluing, or a fixed limiting structure can be provided on the bracket plate, and the magnet is installed in the fixed limiting structure.

Furthermore, the mounting gap 78 can be flexibly arranged according to the actual size of the magnet group 5, and can be controlled by the connection structure between the first bracket plate 76 and the second bracket plate 77. For example, the connection structure includes but is not limited to a bolts, and the size of the mounting gap 78 can be changed by adjusting the length of the bolt connecting the first bracket plate 76 and the second bracket plate 77. At the same time, the first bracket plate 76 and the second bracket plate 77 are provided with a sound-transmitting structure. When the diaphragm 100 produces sound, the sound passes through the bracket plates and is heard by the user. By providing a sound-transmitting structure on the bracket plate, the problem of sound being blocked can be effectively solved. One implementation of the bracket plate is that the bracket plate is a circular structure, and the square hole in the middle of the bracket plate is the sound-transmitting structure. Another implementation of the bracket plate is that a plurality of square hole structures is arranged on the bracket plate, and the plurality of square hole structures is arranged with an interval along the length direction of the bracket plate. Meanwhile, in another embodiment of the present disclosure, the sound-transmitting structure is a plurality of hole structures opened on the bracket plate, and the hole structure may be a round hole, a square hole or a special-shaped hole.

Furthermore, there are many ways to arrange the magnet group 5 between the bracket plates. Referring to FIG. 22, in one embodiment of the present disclosure, the length direction of each magnet group 5 is the same as the width direction of the bracket plate, and a plurality of magnet groups 5 is arranged with an interval along the length direction of the bracket plate. At the same time, in the width direction of the bracket plate, in addition to arranging one magnet group 5, a plurality of (2 or more) magnet groups 5 can also be arranged side by side. Referring to FIG. 24, in another embodiment of the present disclosure, the length direction of each magnet group 5 is the same as the length direction of the bracket plate, and the plurality of magnet groups 5 is arranged with an interval along the width direction of the bracket plate. The magnet in each magnet group 5 may be a long strip magnet, or a long strip magnet with a longer length combined by a plurality of long strip magnet groups 5. By arranging the magnet group 5 in the mounting gap 78 in different ways, the sounding unit can be adapted to the diaphragm of different structures. In summary, in the technical solution provided in the embodiment of the present disclosure, a viscoelastic connection structure is provided on the insulating film, and the insulating film is fixedly connected through the viscoelastic connection structure. When the diaphragm vibrates, the vibration energy transmitted from the diaphragm is absorbed by the viscoelastic connection structure, thereby reducing the negative impact of the vibration on the vibration of the diaphragm itself. The viscoelastic connection structure 600 provides sufficient tension for the diaphragm, thereby increasing the amplitude of the diaphragm and reducing the bass loss. At the same time, the delay in the time domain of sound generation is reduced, so as to better show the state of the original sound when the sound is played. At the same time, when the energized diaphragm vibrates under the action of the magnetic field of the magnet, it vibrates inside and outside the sounding cavity. The sound waves front and behind the diaphragm will not offset each other, so there will be no loss of bass, and the full range of sound can be covered with a smaller volume and one single sounding element.

It is finally to be noted that the above embodiments are adopted not to limit but only to describe the technical solutions of the present disclosure. Although the present disclosure has been described with reference to the abovementioned embodiments in detail, those of ordinary skill in the art should know that modifications may still be made to the technical solutions recorded in each embodiment or equivalent replacements may be made to part of technical features therein. These modifications or replacements do not make the essences of the corresponding technical solutions depart from the spirit and scope of the technical solutions of each embodiment of the present disclosure.

## Claims

1. A diaphragm, comprising:
at least one insulating film, wherein the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit.

2. The diaphragm according to claim 1, wherein one insulating film is provided, the insulating film comprises a first surface and a second surface arranged opposite to each other;
the plurality of conductive films is all connected with the first surface; or
the plurality of conductive films comprises a plurality of first sub-films and a plurality of second sub-films, wherein the plurality of first sub-films is arranged on the first surface, the plurality of second sub-films is arranged on the second surface, and the first sub-films and the second sub-films are arranged with an interval.

3. The diaphragm according to claim 1, wherein two stacked insulating films are provided, and the plurality of conductive films is arranged between the two insulating films.

4. The diaphragm according to claim 3, wherein an insulating structure is provided between two adjacent conductive films.

5. The diaphragm according to claim 1, wherein the insulating film comprises a plurality of insulating films, and the plurality of insulating films and the plurality of conductive films are sequentially connected at intervals.

6. The diaphragm according to claim 5, wherein the insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

7. The diaphragm according to any one of claims 1 to 6, wherein the connecting piece comprises a connecting film arranged on the insulating film; or
the connecting piece comprise a conductive wire.

8. The diaphragm according to any one of claims 1 to 6, wherein the conductive film is provided with a feedback wire, and the feedback wire extends along a direction of current flow in the energized circuit.

9. The diaphragm according to any one of claims 1 to 6, wherein the conductive film comprises at least one of gold, silver, copper, iron, aluminum, graphite, graphene, carbon fiber, polymer material and composite material.

10. The diaphragm according to any one of claims 1 to 6, wherein the insulating film comprises at least one of spandex material, silicone material, rubber material, polyester film, polyester fiber or other polymer materials.

11. The diaphragm according to any one of claims 1 to 6, wherein each of the conductive films comprises a plurality of segmented films, and each of the plurality of segmented films in each of the conductive films extends along a direction of current flow in the energized circuit;
from one magnetic pole corresponding area to another magnetic pole corresponding area, the plurality of segmented films is arranged with an interval.

12. The diaphragm according to claim 11, wherein one insulating film is provided, the insulating film comprises a first surface and a second surface arranged opposite to each other;
the plurality of the segmented films is all connected with the first surface, and an insulating structure is provided between two adjacent segmented films; or
the plurality of segmented films comprises a plurality of first sub-segmented films and a plurality of second sub-segmented films, the plurality of first sub-segmented films is arranged on the first surface, the plurality of second sub-segmented films is arranged on the second surface, and the first sub-segmented films and the second sub-segmented films are arranged with an interval.

13. The diaphragm according to claim 11, wherein two stacked insulating films are provided, and the plurality of segmented films is arranged between the two insulating films.

14. The diaphragm according to claim 13, wherein an insulating structure is provided between two adjacent segmented films.

15. The diaphragm according to claim 11, wherein from one magnetic pole corresponding area to another magnetic pole corresponding area, sizes of the plurality of segmented films are equal, or, a size of the segmented film becomes larger when be closer to the magnetic pole corresponding area.

16. An audio device, comprising the diaphragm according to any one of claims 1 to 15;
a plurality of magnet groups, wherein the plurality of magnet groups is arranged with an interval, each of the magnet groups comprises a pair of magnets with the same magnetic poles arranged opposite to each other, an opposing gap is provided between each pair of the magnets, and an energized gap is provided between two adjacent magnet groups with opposite magnetic poles arranged opposite to each other; and
the diaphragm is passed through the opposing gap, each of the magnet groups is arranged corresponding to one magnetic pole corresponding area, and the conductive film is arranged in the energized gap.

17. The audio device according to claim 16, further comprising: a plurality of magnetic conductors, and two adjacent magnet groups with opposite magnetic poles arranged opposite to each other are respectively connected with two ends of the magnetic conductors.

18. The audio device according to claim 16, further comprising: a signal input circuit, a signal amplifier and a feedback circuit; wherein,
the signal input circuit has an input end and an output end, the input end is used to receive an external input signal, and the output end is connected with the signal amplifier;
the signal amplifier has an input port and an output port, the input port is connected with the output end, and the output port is connected with the energized circuit on the diaphragm; and
the feedback wire on the conductive film is connected with one end of the feedback circuit, and the other end of the feedback circuit is connected with the input port.

19. A diaphragm, comprising:
at least one insulating film, wherein the insulating film is provided with a magnetic pole corresponding area;
a plurality of conductive films, wherein each of the conductive films is at least connected with one of the insulating films, the plurality of conductive films is arranged with an interval, and two sides of each of the conductive films are provided with the magnetic pole corresponding area respectively.

20. A sounding unit, comprising:
a mounting bracket, wherein the mounting bracket has a magnet mounting area and a diaphragm mounting area;
a plurality of magnet groups, wherein the plurality of magnet groups is arranged in the magnet mounting area and is arranged with an interval, each of the magnet groups comprises a pair of magnets with the same magnetic poles arranged opposite to each other, an opposing gap is provided between each pair of the magnets, and a circuit placement area is provided between two adjacent magnet groups with opposite magnetic poles arranged opposite to each other;
a diaphragm, wherein the diaphragm is arranged in the diaphragm mounting area, the diaphragm is provided with a plurality of magnetic pole corresponding areas and an energized circuit, the diaphragm is passed through the opposing gap, each of the magnet groups is arranged corresponding to one magnetic pole corresponding area, and the energized circuit is arranged in the circuit placement area.

21. The sounding unit according to claim 20, wherein the magnet group is arranged along a height direction of the mounting bracket to form a magnet column, and a plurality of the magnet columns is arranged with an interval along a width direction of the mounting bracket;
one magnet group is arranged in the magnet column, and the opposing magnetic poles of two magnet groups in adjacent magnet columns are opposite; or
a plurality of magnet groups is provided in the magnet column, and the plurality of magnet groups is arranged with an interval along a height direction of the mounting bracket, in the same magnet column, the opposing magnetic poles of two adjacent magnet groups are the same, and the opposing magnetic poles of two magnet groups in adjacent magnet columns are opposite.

22. The sounding unit according to claim 21, further comprising: a plurality of magnetic conductors, wherein the plurality of magnetic conductors is arranged with an interval along a height direction of the mounting bracket, and a gap is provided between two adjacent magnetic conductors;
the magnetic conductor extends along a width direction of the mounting bracket and spans across the plurality of magnet columns, and is respectively connected with the magnet group with opposite magnetic poles arranged opposite to each other in adjacent magnet columns.

23. The sounding unit according to claim 22, wherein a pole of the magnet column facing away from the diaphragm is provided with a magnetic field conductor, the magnetic conductor is connected with the magnetic field conductor.

24. The sounding unit according to any one of claims 20 to 23, wherein the mounting bracket comprises an upper bracket plate, a lower bracket plate and a plurality of pairs of vertical plates;
the plurality of pairs of the vertical plates is arranged with an interval between the upper bracket plate and the lower bracket plate, and an accommodation gap is provided between two the vertical plates in pairs;
at least one of the upper bracket plate and the lower bracket plate is provided with a mounting hole, the mounting hole extends along an arrangement direction of the plurality of pairs of vertical plates and corresponding to the accommodation gap;
a side of the vertical plate facing the accommodation gap is the magnet mounting area, and the accommodation gap and the mounting hole form the diaphragm mounting area.

25. The sounding unit according to any one of claims 20 to 23, wherein the mounting bracket comprises a first bracket plate and a second bracket plate;
the first bracket plate and the second bracket plate are arranged opposite to each other, and a mounting gap is provided between the first bracket plate and the second bracket plate;
the magnet group is arranged in the mounting gap, and one magnet in each of the magnet groups is connected with the first bracket plate, and the other magnet is connected with the second bracket plate;
the first bracket plate and the second bracket plate are provided with a sound-transmitting structure.

26. The sounding unit according to any one of claims 20 to 23, wherein the diaphragm comprises:
at least one insulating film, wherein the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit.

27. The sounding unit according to claim 26, wherein one insulating film is provided, the insulating film comprises a first surface and a second surface arranged opposite to each other;
the plurality of conductive films is all connected with the first surface; or
the plurality of conductive films comprises a plurality of first sub-films and a plurality of second sub-films, wherein the plurality of first sub-films is arranged on the first surface, the plurality of second sub-films is arranged on the second surface, and the first sub-films and the second sub-films are arranged with an interval.

28. The sounding unit according to claim 26, wherein two stacked insulating films are provided, and the plurality of conductive films is arranged between the two insulating films.

29. The sounding unit according to claim 28, wherein an insulating structure is provided between two adjacent conductive films.

30. The sounding unit according to claim 26, wherein the insulating film comprises a plurality of insulating films, and the plurality of insulating films and the plurality of conductive films are sequentially connected at intervals.

31. The sounding unit according to claim 30, wherein the insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

32. The sounding unit according to claim 26, wherein the connecting piece comprises a connecting film arranged on the insulating film; or
the connecting piece comprise a conductive wire.

33. The sounding unit according to claim 26, wherein the conductive film is provided with a feedback wire, and the feedback wire extends along a direction of current flow in the energized circuit.

34. The sounding unit according to claim 26, wherein each of the conductive films comprises a plurality of segmented films, and each of the plurality of segmented films in each of the conductive films extends along a direction of current flow in the energized circuit;
from one magnetic pole corresponding area to another magnetic pole corresponding area, the plurality of segmented films is arranged with an interval.

35. The sounding unit according to claim 34, wherein one insulating film is provided, the insulating film comprises a first surface and a second surface arranged opposite to each other;
the plurality of the segmented films is all connected with the first surface, and an insulating structure is provided between two adjacent segmented films; or
the plurality of segmented films comprises a plurality of first sub-segmented films and a plurality of second sub-segmented films, the plurality of first sub-segmented films is arranged on the first surface, the plurality of second sub-segmented films is arranged on the second surface, and the first sub-segmented films and the second sub-segmented films are arranged with an interval.

36. The sounding unit according to claim 34, wherein two stacked insulating films are provided, and the plurality of segmented films is arranged between the two insulating films.

37. The sounding unit according to claim 36, wherein an insulating structure is provided between two adjacent segmented films.

38. The sounding unit according to claim 37, wherein from one magnetic pole corresponding area to another magnetic pole corresponding area, sizes of the plurality of segmented films are equal, or, a size of the segmented film becomes larger when be closer to the magnetic pole corresponding area.

39. An audio device, comprising: a device main body and the sounding unit according to any one of claims 1 to 38 arranged on the device main body.

40. The audio device according to claim 39, further comprising: a signal input circuit, a signal amplifier and a feedback circuit; wherein,
the signal input circuit has an input end and an output end, the input end is used to receive an external input signal, and the output end is connected with the signal amplifier;
the signal amplifier has an input port and an output port, the input port is connected with the output end, and the output port is connected with the energized circuit on the diaphragm; and
the feedback wire on the conductive film is connected with one end of the feedback circuit, and the other end of the feedback circuit is connected with the input port.

41. A diaphragm, comprising:
at least one insulating film, wherein the insulating film is an open mesh or a non-open film made of viscoelastic material; the insulating film has a connecting end, and the connecting end is provided with a viscoelastic connection structure; the insulating film is provided with a magnetic pole corresponding area;
a plurality of conductive films, wherein each of the conductive films is connected with at least one of the insulating films, the plurality of conductive films is arranged with an interval, and two sides of each of the conductive films are provided with the magnetic pole corresponding area respectively; and
a plurality of connecting pieces, wherein the plurality of the conductive films is connected in series via the plurality of connecting pieces to form an energized circuit.

42. The diaphragm according to claim 41, wherein the insulating film is one of a spandex open mesh, a silicone film, a rubber film, a polyester film, and a polyester fiber film having viscoelastic properties.

43. The diaphragm according to claim 41, wherein the viscoelastic connection structure is a viscoelastic glue.

44. The diaphragm according to claim 41, wherein a plurality of weakening structures for reducing a strength of the conductive film are provided on the conductive film.

45. The diaphragm according to claim 44, wherein the weakening structure includes a pleated structure and/or a hole structure.

46. The diaphragm according to any one of claims 41 to 45, wherein one insulating film is provided, the insulating film comprises a first surface and a second surface arranged opposite to each other;
the plurality of the segmented films is all connected with the first surface, and an insulating structure is provided between two adjacent segmented films; or
the plurality of segmented films comprises a plurality of first sub-segmented films and a plurality of second sub-segmented films, the plurality of first sub-segmented films is arranged on the first surface, the plurality of second sub-segmented films is arranged on the second surface, and the first sub-segmented films and the second sub-segmented films are arranged with an interval.

47. The diaphragm according to any one of claims 41 to 45, wherein two stacked insulating films are provided, and the plurality of conductive films is arranged between the two insulating films.

48. The diaphragm according to any one of claims 41 to 45, wherein the insulating film comprises a plurality of insulating films, and the plurality of insulating films and the plurality of conductive films are sequentially connected at intervals.

49. The diaphragm according to claim 48, wherein the insulating film comprises a first surface and a second surface arranged opposite to each other, and a side surface arranged between the first surface and the second surface;
the plurality of conductive films is all connected with the first surface; or, the plurality of conductive films is all connected with the side surface; or, two sides of the conductive film are respectively provided with the insulating film, and the conductive film is connected with the first surface of one of the insulating films and to the second surface of another insulating film.

50. The diaphragm according to any one of claims 41 to 45, wherein the connecting piece comprises a connecting film arranged on the insulating film; or
the connecting piece comprise a conductive wire.

51. The diaphragm according to any one of claims 41 to 45, wherein the conductive film is provided with a feedback wire, and the feedback wire extends along a direction of current flow in the energized circuit.

52. The diaphragm according to any one of claims 41 to 45, wherein each of the conductive films comprises a plurality of segmented films, and each of the plurality of segmented films in each of the conductive films extends along a direction of current flow in the energized circuit;
from one magnetic pole corresponding area to another magnetic pole corresponding area, the plurality of segmented films is arranged with an interval.

53. The diaphragm according to claim 52, wherein from one magnetic pole corresponding area to another magnetic pole corresponding area, sizes of the plurality of segmented films are equal, or, a size of the segmented film becomes larger when be closer to the magnetic pole corresponding area.

54. An audio device, comprising: the diaphragm according to any one of claims 1 to 13, and
a plurality of magnets, wherein the plurality of magnets is arranged respectively corresponding to the magnetic pole corresponding area, and the energized circuit is located between two adjacent magnets with opposite magnetic poles facing the diaphragm.

55. The audio device according to claim 54, wherein the plurality of magnets comprises a plurality of magnet groups, each of the magnet groups comprises a pair of magnets with the same magnetic poles arranged opposite to each other, an opposing gap is provided between each pair of the magnets, and an energized gap is provided between two adjacent magnet groups with opposite magnetic poles arranged opposite to each other;
the diaphragm is passed through the opposing gap, and the energized circuit is arranged in the energized gap.

56. The audio device according to claim 54, wherein the plurality of magnets comprises a plurality of first sub-magnets and a plurality of second sub-magnets, and the magnetic poles of the first sub-magnets facing the diaphragm are opposite to the magnetic poles of the second sub-magnets facing the diaphragm;
the plurality of first sub-magnets and the plurality of second sub-magnets are arranged with an interval and staggered on opposite sides of the diaphragm; or, the plurality of first sub-magnets and the plurality of second sub-magnets are arranged with an interval on the same side of the diaphragm.

57. The audio device according to claim 56, wherein when the plurality of the first sub-magnets and the plurality of the second sub-magnets are arranged with an interval on the same side of the diaphragm, a sound insulation structure is provided between the first sub-magnet and the second sub-magnet.

58. The audio device according to claim 54, further comprising: a signal input circuit, a signal amplifier and a feedback circuit; wherein,
the signal input circuit is connected with the signal amplifier, and the signal amplifier is connected with the diaphragm; and
the feedback circuit is respectively connected with the feedback wire on the conductive film in the diaphragm and the signal amplifier, and is used to feed back a vibration frequency of the diaphragm in the diaphragm to the signal amplifier.
